(19) Europäisches Patentamt / European Patent Office / Office européen des brevets

(11) **EP 3 799 229 B1**

(12) **EUROPEAN PATENT SPECIFICATION**

(45) Date of publication and mention
of the grant of the patent:
**06.03.2024 Bulletin 2024/10**

(21) Application number: **19807695.2**

(22) Date of filing: **15.03.2019**

(51) International Patent Classification (IPC):
*H01S 5/0239* $^{(2021.01)}$   *H01S 5/024* $^{(2006.01)}$
*H01S 5/0237* $^{(2021.01)}$   *H01S 5/40* $^{(2006.01)}$
*H01S 5/042* $^{(2006.01)}$   *H01S 5/022* $^{(2021.01)}$
*H01L 23/473* $^{(2006.01)}$   *H01S 5/02365* $^{(2021.01)}$

(52) Cooperative Patent Classification (CPC):
**H01S 5/0237; H01L 23/473; H01S 5/0239;
H01S 5/02423; H01S 5/04254; H01S 5/04256;
H01S 5/4018; H01S 5/4025; H01S 5/4031;**
H01S 5/02365

(86) International application number:
**PCT/JP2019/010978**

(87) International publication number:
**WO 2019/225128 (28.11.2019 Gazette 2019/48)**

(54) **SEMICONDUCTOR LASER DEVICE**

HALBLEITERLASERVORRICHTUNG

DISPOSITIF LASER À SEMI-CONDUCTEUR

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **21.05.2018 JP 2018097377**

(43) Date of publication of application:
**31.03.2021 Bulletin 2021/13**

(73) Proprietor: **Panasonic Intellectual Property
Management Co., Ltd.
Osaka-shi, Osaka 540-6207 (JP)**

(72) Inventor: **OOMORI, Kouji
Osaka-shi, Osaka 540-6207 (JP)**

(74) Representative: **Vigand, Philippe et al
Novagraaf International SA
Chemin de l'Echo 3
1213 Onex - Genève (CH)**

(56) References cited:
EP-A2- 2 485 346     WO-A1-2009/049799
WO-A1-2016/063436     WO-A1-2016/103536
JP-A- 2004 186 212     JP-A- 2004 515 086
JP-A- 2005 158 902     JP-A- 2005 353 614
JP-A- 2009 076 730     JP-A- 2013 191 787
JP-A- 2015 176 975     US-A- 4 719 631
US-A1- 2008 025 361     US-A1- 2012 167 649
US-A1- 2014 204 968     US-A1- 2017 149 205
US-A1- 2017 301 604     US-A1- 2018 062 348
US-B1- 8 483 249

# Description

## TECHNICAL FIELD

The present invention relates to a semiconductor laser device, and more particularly to a semiconductor laser device having a heat dissipation block formed with a flow path through which a coolant flows.

## BACKGROUND ART

In recent years, there is an increasing demand for metal processing using laser light, and higher output of a laser device is required. Thus, a semiconductor laser device using a semiconductor laser element having high optical-electrical conversion efficiency attracts attention. However, increase in output of a semiconductor laser device increases the amount of current flowing into a semiconductor laser element, so that temperature of the semiconductor laser element rises due to Joule heat. This may cause a degradation in performance, a deterioration of an element, a failure, or the like.

Thus, there has been conventionally proposed a semiconductor laser device having a structure in which a semiconductor laser element and a sub-mount are held between electrode blocks from above and below to discharge heat generated in the semiconductor laser element through the electrode blocks. PTL 1 discloses a structure including a first electrode block provided with a semiconductor laser element and a sub-mount, and a second electrode block provided covering the semiconductor laser element and the sub-mount from above, the blocks being integrated by tightening a screw into a screw hole provided in each member.

Additionally, there has been proposed a structure in which a flow path for allowing cooling water to flow is provided in a heat sink provided with a semiconductor laser element and a sub-mount to cool the semiconductor laser element (e.g., refer to PTLs 2 and 3).

## Citation List

### Patent Literature

PTL 1: International Publication No. WO 2016/103536
PTL 2: Unexamined Japanese Patent Publication No. 2008-172141
PTL 3: Japanese Patent No. 3951919
PTL 4: European Patent Application No. EP 2 485 346 A2 discloses clamp technology for horizontal assembly of laser-diode bars.

# SUMMARY OF THE INVENTION

## Technical problem

Conventional structure as disclosed in PTLs 2 and 3 requires an insulating portion made of an insulating material such as resin or ceramic to be provided between a heat sink through which cooling water flows and a semiconductor laser element for electrically insulating both the heat sink and the semiconductor laser element.

Unfortunately, an insulating material generally has a low thermal conductivity, so that providing the insulating portion above reduces efficiency of discharging heat generated in the semiconductor laser element. This causes output of the semiconductor laser device to be hindered from increasing.

The present invention is made in view of the above points, and an object thereof is to provide a semiconductor laser device having high cooling efficiency, including a semiconductor laser element disposed on a heat dissipation block provided inside with a flow path through which a coolant flows.

## Solution to problem

To achieve the above object, a semiconductor laser device according to the present invention includes at least a heat dissipation block provided inside with a flow path through which a coolant flows, and first and second semiconductor laser modules disposed on the heat dissipation block. The heat dissipation block includes a lower heat dissipation block formed with a groove constituting the flow path, an insulating sealant disposed in contact with an upper surface of the lower heat dissipation block, having an opening above the groove, and an upper heat dissipation block made of a conductive material disposed in contact with an upper surface of the insulating sealant, covering the opening. The first semiconductor laser module is disposed in contact with an upper surface of the upper heat dissipation block, having a positive electrode side facing down, and the second semiconductor laser module is disposed in contact with the upper surface of the upper heat dissipation block, having a negative electrode side facing down.

This configuration enables the upper heat dissipation block located above the opening of the insulating sealant to be directly cooled by the coolant, so that cooling efficiency of the semiconductor laser module can be improved by promptly discharging heat generated in the first and second semiconductor laser modules disposed in contact with the upper surface of the upper heat dissipation block to outside the semiconductor laser device using the coolant. Additionally, the amount of current flowing into the semiconductor laser element can be increased, so that the semiconductor laser device can have a high output.

Advantageous effect of invention

The semiconductor laser device of the present invention enables improving the cooling efficiency of the semiconductor laser module. The semiconductor laser device also can have a high output.

BRIEF DESCRIPTION OF DRAWINGS

FIG. 1 is a perspective view illustrating a structure of a semiconductor laser device according to a first exemplary embodiment of the present invention.
FIG. 2 is a schematic diagram illustrating a front side surface of the semiconductor laser device.
FIG. 3 is an exploded perspective view of a heat dissipation block.
FIG. 4A is a perspective view illustrating a structure of a semiconductor laser module.
FIG. 4B is an exploded perspective view of the semiconductor laser module illustrated in FIG. 4A.
FIG. 5A is a schematic diagram illustrating a front side surface of a semiconductor laser device according to a first modification.
FIG. 5B is a schematic diagram illustrating a front side surface of another semiconductor laser device according to the first modification.
FIG. 6A is a schematic diagram illustrating a front side surface of a semiconductor laser device for comparison.
FIG. 6B is a schematic diagram illustrating a front side surface of a semiconductor laser device according to a second modification.
FIG. 7 is an exploded perspective view illustrating a structure of a semiconductor laser device according to a second exemplary embodiment of the present invention.
FIG. 8 is a schematic diagram illustrating a front side surface of the semiconductor laser device.
FIG. 9 is an exploded perspective view of an additional heat dissipation block.

DESCRIPTION OF EMBODIMENT

Hereinafter, exemplary embodiments of the present invention will be described in detail with reference to the drawings. Descriptions of the preferred exemplary embodiments described below are each intrinsically an example, and are not intended to limit the present invention, and an application or a use of the present invention.

(First exemplary embodiment)

[Structure of semiconductor laser device and its components]

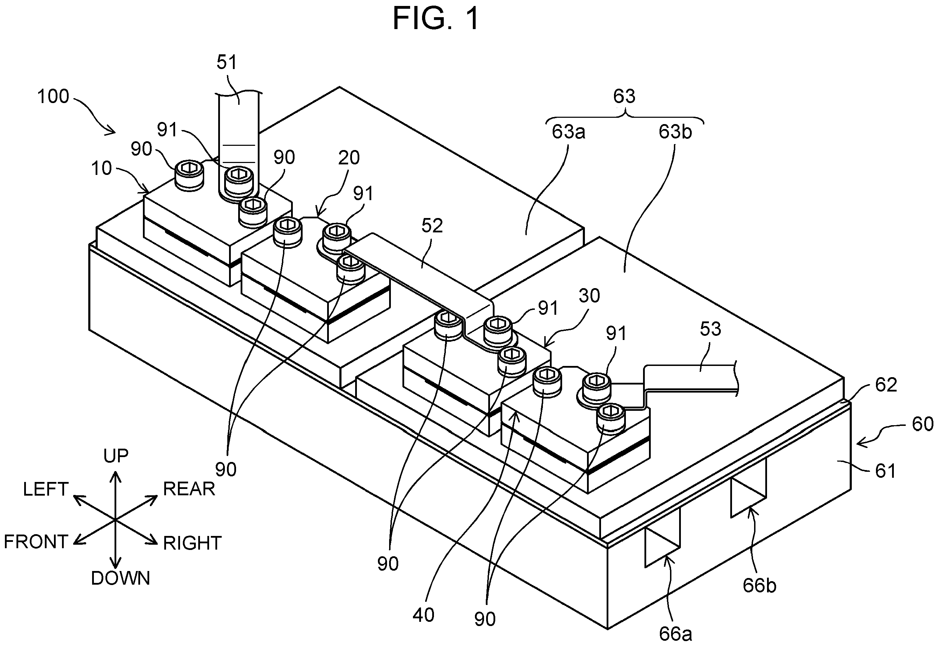

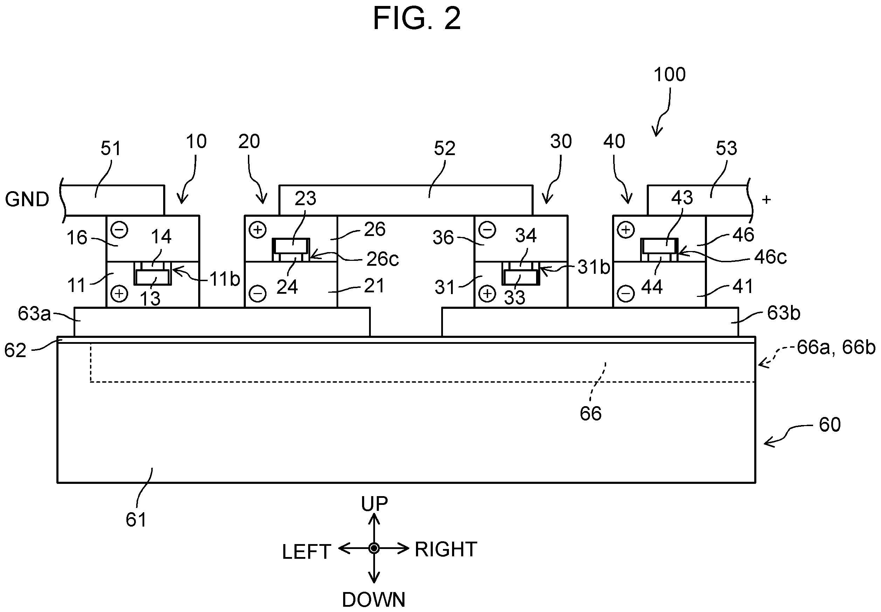

FIG. 1 shows a perspective view of a semiconductor laser device according to the present exemplary embodiment, and FIG. 2 shows a schematic view of a front side surface. FIG. 2 exemplarily illustrates a structure of semiconductor laser device 100 and each part as a schematic diagram. Thus, shapes, positions, placement relationships, and dimensions of respective parts in FIG. 2 are different from actual relationships. For convenience of description, details of first to fourth semiconductor laser modules 10, 20, 30, 40, heat dissipation block 60, and bus bars 51 to 53 are eliminated in FIG. 2. Illustrations of module fixing screw 90 and terminal fixing screw 91 are also eliminated.

In the following description, a side of semiconductor laser device 100 in FIGS. 1 and 2, on which heat dissipation block 60 is disposed, may be referred to as a lower side or down, and an opposite side thereof, i.e., a side thereof on which first to fourth semiconductor laser modules 10, 20, 30, 40 are disposed, may be referred to as an upper side or up. Then, a side of heat dissipation block 60, on which inflow port 66a and discharge port 66b are provided, may be referred to as a right side or right, and an opposite side thereof may be referred to as a left side or left. Additionally, sides of first to fourth semiconductor laser modules 10, 20, 30, 40, on which laser light emitting end surfaces of semiconductor laser elements 14, 24, 34, 44 are respectively disposed, may be each referred to as a front side or front, and opposite sides thereof may be each referred to as a rear side or rear.

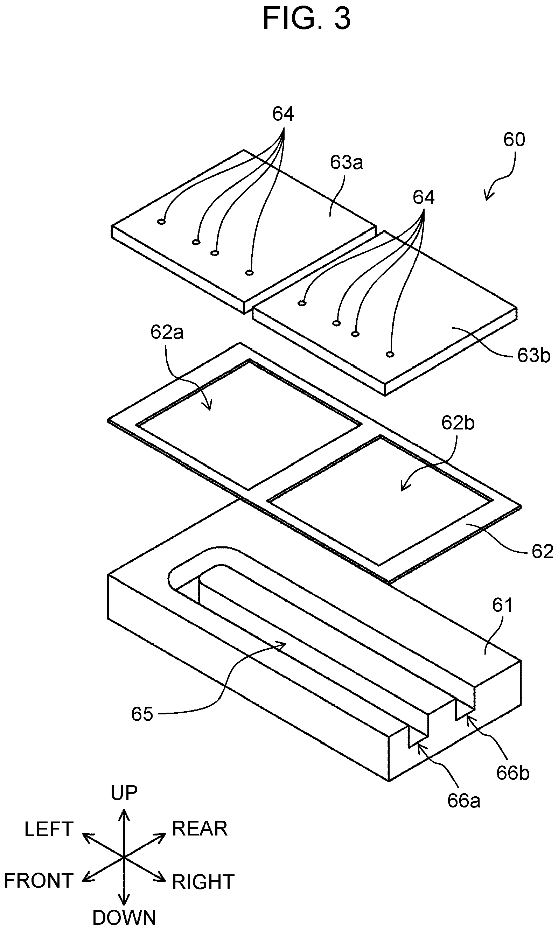

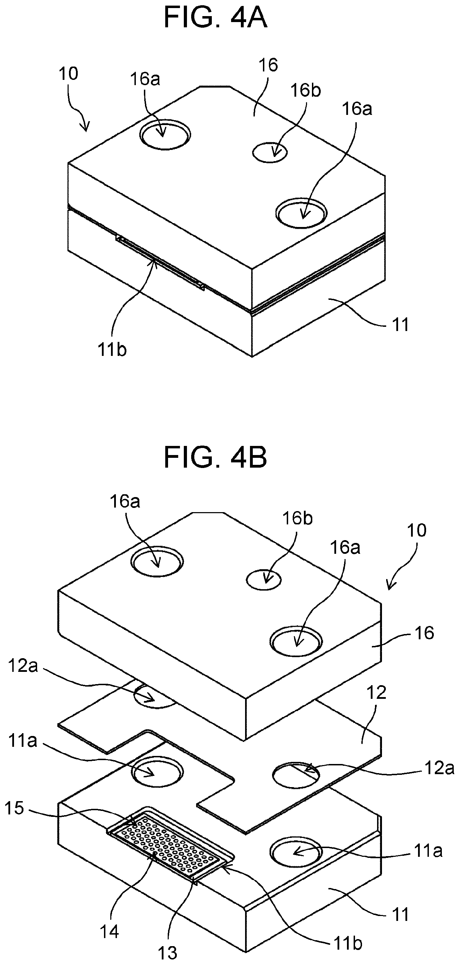

FIG. 3 shows an exploded perspective view of a heat dissipation block. FIG. 4A shows a perspective view of a semiconductor laser module, and FIG. 4B shows an exploded perspective view of the semiconductor laser module illustrated in FIG. 4A. For convenience of description, FIGS. 4A and 4B each illustrate only first semiconductor laser module 10.

As illustrated in FIG. 1, semiconductor laser device 100 includes heat dissipation block 60, first to fourth semiconductor laser modules 10, 20, 30, 40, and bus bars 51 to 53.

As illustrated in FIG. 3, heat dissipation block 60 includes lower heat dissipation block 61, insulating sealant 62, and first and second upper heat dissipation blocks 63a and 63b. Lower heat dissipation block 61 and insulating sealant 62, and insulating sealant 62 and first and second upper heat dissipation block 63a, 63b, are each bonded with an adhesive having predetermined heat resistance. However, a method for bonding these members is not particularly limited to this. For example, screw holes (not illustrated) may be provided at four respective corners of each of lower heat dissipation block 61, insulating sealant 62, and first and second upper heat dissipation blocks 63a and 63b to fasten these members to each other with screws or the like (not illustrated). In that case, to insulate first and second upper heat dissipation blocks 63a and 63b from lower heat dissipation block 61, the members are preferably fastened to each other using the screw holes each having an inner surface coated with an insulating material, or screws made of an insulating material or screws coated with an insulating material.

Heat dissipation block 60 is provided inside with flow path 66 in a U-shape in top view. Inflow port 66a for a coolant is provided on a right side of heat dissipation block 60 close to a front side thereof, and discharge port 66b therefor is provided on the right side of heat dissipation block 60 and on a rear side of inflow port 66a at a predetermined interval. The coolant supplied from outside flows into inflow port 66a, and passes through the flow path to be discharged outside from discharge port 66b. Cooling water having resistivity adjusted to a predetermined value or more is used as the coolant in the present exemplary embodiment, and the resistivity of the cooling water is preferably managed to prevent leakage of electricity from first and second upper heat dissipation blocks 63a, 63b through the coolant.

Lower heat dissipation block 61 is a metal member made of, for example, copper, a copper-aluminum alloy, or a laminated body of copper and aluminum, and is provided in its upper surface with groove portion 65 constituting flow path 66. The upper surface other than groove portion 65 is flat.

Insulating sealant 62 is made of a material having a predetermined insulating property, and is made of, for example, an insulating resin or ceramic. Insulating sealant 62 is disposed in contact with the upper surface of lower heat dissipation block 61 except groove portion 65. Insulating sealant 62 is also provided with openings 62a and 62b at a predetermined interval, and openings 62a and 62b are located above groove portion 65 in top view. Openings 62a and 62b pass through insulating sealant 62 in its thickness direction. Insulating sealant 62 electrically insulates first and second upper heat dissipation blocks 63a, 63b from lower heat dissipation block 61, and also functions as a sealant that prevents the cooling water from leaking from flow path 66.

First and second upper heat dissipation blocks 63a, 63b are metal members made of the same material as the lower heat dissipation block 61, and are disposed in contact with an upper surface of insulating sealant 62, covering openings 62a, 62b of insulating sealant 62, respectively. First and second upper heat dissipation blocks 63a, 63b are disposed away from each other at a predetermined interval. This allows first and second semiconductor laser modules 10, 20 disposed on an upper surface of first upper heat dissipation block 63a to be electrically insulated and isolated from third and fourth semiconductor laser modules 30, 40 disposed on an upper surface of second upper heat dissipation block 63b. However, as described later, second semiconductor laser module 20 and third semiconductor laser module 30 are electrically connected using bus bar 52. First and second upper heat dissipation blocks 63a, 63b each may be made of a material different from that of lower heat dissipation block 61. However, first and second upper heat dissipation blocks 63a, 63b each need to be made of a conductive material because a current at predetermined magnitude flows therethrough as described later.

First and second upper heat dissipation blocks 63a, 63b are each provided on its front side with a plurality of screw holes 64. Screw holes 64 do not pass through corresponding first and second upper heat dissipation blocks 63a, 63b, and have bottom surfaces located inside corresponding first and second upper heat dissipation blocks 63a, 63b. First semiconductor laser module 10 is attached and fixed to first upper heat dissipation block 63a using module fixing screws 90 inserted into respective screw holes 11a, 16a provided in first semiconductor laser module 10 (see FIG. 4B) and screw holes provided in first upper heat dissipation block 63a. Similarly, second semiconductor laser module 20 is fixed to first upper heat dissipation block 63a, and third and fourth semiconductor laser modules 30, 40 are fixed to second upper heat dissipation block 63b. The upper surfaces of first and second upper heat dissipation blocks 63a and 63b are flat except portions provided with screw holes 64.

As illustrated in FIGS. 4A and 4B, first semiconductor laser module 10 includes lower electrode block 11, insulating sheet 12, sub-mount 13, semiconductor laser element 14, and upper electrode block 16. Although not illustrated, second to fourth semiconductor laser modules 20, 30, 40 also each have the same structure. Thus, the structure of first semiconductor laser module 10 will be described below as an example.

Lower electrode block 11 is a thick plate member made of a conductive material. For example, lower electrode block 11 is obtained by plating a plate material made of copper (Cu) with nickel (Ni) and gold (Au) in this order. Lower electrode block 11 is disposed with its lower surface in contact with the upper surface of first upper heat dissipation block 63a. Lower electrode block 11 includes recessed portion 11b in a cut-out shape that is opened by cutting out a part of the upper surface and front side surface of lower electrode block 11. Recessed portion 11b accommodates sub-mount 13 and semiconductor laser element 14, and laser light is emitted from semiconductor laser element 14 through a front opening of recessed portion 11b. Lower electrode block 11 also includes screw holes 11a provided on right and left sides of recessed portion 11b one by one separately from recessed portion 11b, screw holes 11a passing through lower electrode block 11. A screw hole (not illustrated) is further provided behind screw holes 11a and on a line passing through between two screw holes 11a in top view. This screw hole opens on the upper surface of lower electrode block 11, having a bottom surface located inside lower electrode block 11, and accommodates terminal fixing screw 91 illustrated in FIG. 1. Lower electrode block 11 is disposed on the upper surface of first upper heat dissipation block 63a, having screw holes 11a that communicate with corresponding screw holes 64 provided in first upper heat dissipation block 63a. Lower electrode block 11 has a lower surface that is flat except portions provided with screw holes 11a, and an upper surface that is flat except portions provided with a screw hole (not illustrated) for accommodating terminal fixing screw 91 and recessed portion 11b.

Insulating sheet 12 is provided on the upper surface of the lower electrode block 11, surrounding recessed portion 11b, and includes openings 12a at positions corresponding to respective screw holes 11a provided in lower electrode block 11. Insulating sheet 12 has a function of electrically insulating upper electrode block 16 and lower electrode block 11 when upper electrode block 16 is attached to lower electrode block 11. Insulating sheet 12 is made of an insulating material such as polyimide or ceramic, for example.

Sub-mount 13 is made of a conductive material such as copper tungsten (Cu:W), for example. As illustrated in FIG. 4B, sub-mount 13 is disposed in recessed portion 11b such that the front side surface of lower electrode block 11 and a front side surface of sub-mount 13 are substantially aligned with each other. Sub-mount 13 and lower electrode block 11 are bonded and electrically connected using a solder material (not illustrated). The solder material contains, for example, 96.5% tin (Sn) and 3.5% silver (Ag).

Semiconductor laser element 14 is an edge-emitting semiconductor laser element. Semiconductor laser element 14 is provided on its lower surface with an upper electrode and on its upper surface with a lower electrode (both not illustrated). When the upper electrode is disposed on an upper surface of sub-mount 13 with gold tin (Au-Sn) solder or the like (not illustrated) interposed therebetween, semiconductor laser element 14 is electrically connected to sub-mount 13. In the present exemplary embodiment, the upper electrode of semiconductor laser element 14 is a positive electrode (+pole), and the lower electrode thereof is a negative electrode (-pole). The upper electrode of semiconductor laser element 14 may be in direct contact with the upper surface of sub-mount 13. The lower electrode is provided on its upper surface with a plurality of bumps 15. Semiconductor laser element 14 includes a resonator (not illustrated) extending in a front-rear direction, and a front side surface of semiconductor laser element 14 corresponds to the laser light emitting end surface. Semiconductor laser element 14 is disposed on sub-mount 13 such that the laser light emitting end surface and the front side surface of sub-mount 13 are substantially aligned with each other. Semiconductor laser element 14 may include a plurality of resonators.

Each of bumps 15 is a gold bump formed by melting a wire made of gold (Au), for example. Gold is softer than other metals, so that the bumps are deformed when semiconductor laser element 14 and upper electrode block 16 are connected. This enables semiconductor laser element 14 and upper electrode block 16 to be electrically connected well to each other without mechanically damaging them greatly. The material of each of the bumps is not limited to gold, and may be any material that is conductive and can ensure electrical connection between the lower electrode of semiconductor laser element 14 and upper electrode block 16. Although not illustrated, a metal sheet such as gold foil is inserted between each of the bumps and upper electrode block 16. Inserting the metal sheet enables increasing a contact area between each of bumps 15 and the metal sheet, so that contact resistance between each of bumps 15 and upper electrode block 16 can be reduced. The metal sheet is not limited to gold foil, and a sheet made of another conductive material may be used. A plurality of metal sheets may be inserted between each of bumps 15 and upper electrode block 16. When electrical connection between each of bumps 15 and upper electrode block 15 is sufficiently good, no metal sheet is required to be inserted.

Upper electrode block 16 is provided on the upper surface of lower electrode block 11 with insulating sheet 12 interposed therebetween, covering above recessed portion 11b, and is a thick plate member made of a conductive material. For example, lower electrode block 11 is obtained by plating a plate material made of copper (Cu) with nickel (Ni) and gold (Au) in this order. Upper electrode block 16 includes screw holes 16a at positions communicating with corresponding screw holes 11a provided in lower electrode block 11, and screw hole 16b behind screw holes 16a and on a line passing through between two screw holes 16a in top view. Although screw holes 16a pass through upper electrode block 16, screw hole 16b has a bottom surface located inside upper electrode block 16.

Module fixing screws 90 are inserted into screw holes 16a provided in upper electrode block 16, openings 12a provided in insulating sheet 12, screw holes 11a provided in lower electrode block 11, and screw holes 64 provided in first upper heat dissipation block 63a, and then are fastened to position and fix these members. To insulate first upper heat dissipation block 63a from lower heat dissipation block 61, and lower electrode block 11 from upper electrode block 16, the screw holes each preferably have an inner surface coated with an insulating material, or module fixing screws 90 are each preferably made of an insulating material or coated with an insulating material. Upper electrode block 16 has an upper surface and a lower surface that are flat except portions provided with respective screw holes 16a and 16b. Upper electrode block 16 and lower electrode block 11 each have the same thickness except recessed portion 11b, and upper electrode block 11 and lower electrode block 16 are each formed having the same outer shape in top view. In the specification of the present application, "the same thickness" or "the same outer shape" means the same including manufacturing tolerances of upper electrode block 11 and lower electrode block 16, and thus upper electrode block 11 and lower electrode block 16 may not be strictly identical in thickness or outer shape.

[Electrical connection between semiconductor laser modules]

As illustrated in FIG. 1, bus bars 51 to 53 are each a plate-shaped member made of a metal material such as copper. A right end portion of bus bar 51, both end portions of bus bar 52, and a left end portion of bus bar 53 are each formed with an opening (not illustrated). When terminal fixing screw 91 is inserted into the opening provided in bus bar 51 and screw hole 16b provided in upper electrode block 16 of first semiconductor laser module 10 and is tightened, bus bar 51 is attached to first semiconductor laser module 10. Similarly, when terminal fixing screw 91 is inserted into the opening provided in bus bar 53 and a screw hole provided in upper electrode block 46 of fourth semiconductor laser module 40 and is tightened, bus bar 53 is attached to fourth semiconductor laser module 40. Bus bars 51, 53 are each electrically connected to an external power supply (not illustrated). Specifically, bus bar 51 is electrically connected to a power supply terminal (not illustrated) having a ground (GND) potential, and bus bar 53 is electrically connected to a power supply terminal (not illustrated) having a positive potential. Thus, for example, upper electrode block 16 of first semiconductor laser module 10 functions as a negative electrode, and lower electrode block 11 thereof functions as a positive electrode.

When not only terminal fixing screw 91 is inserted into the opening provided at the left end portion of bus bar 52 and a screw hole provided in upper electrode block 26 of second semiconductor laser module 20 and is tightened, but also terminal fixing screw 91 is inserted into the opening provided at the right end portion of bus bar 52 and a screw hole provided in upper electrode block 36 of third semiconductor laser module 30 and is tightened, bus bar 52 is attached to second and third semiconductor laser modules 20, 30.

Here, as illustrated in FIG. 2, semiconductor laser device 100 includes first to fourth semiconductor laser modules 10, 20, 30, 40 that are connected in series. Specifically, bus bar 51 having the ground potential is connected to upper electrode block 16 of first semiconductor laser module 10, so that lower electrode block 11 of first semiconductor laser module 10 and lower electrode block 21 of second semiconductor laser module 20 are electrically connected using first upper heat dissipation block 63a. Bus bar 52 electrically connects upper electrode block 26 of second semiconductor laser module 20 and upper electrode block 36 of third semiconductor laser module 30. Additionally, lower electrode block 31 of third semiconductor laser module 30 and lower electrode block 41 of fourth semiconductor laser module 40 are electrically connected using second upper heat dissipation block 63b, and bus bar 53 having a positive potential is connected to upper electrode block 46 of fourth semiconductor laser module 40. Here, first upper heat dissipation block 63a and second upper heat dissipation block 63b are electrically separated from each other, so that lower electrode blocks 11, 21 of first and second semiconductor laser modules 10, 20 are electrically separated from lower electrode blocks 31, 41 of third and fourth semiconductor laser module 30, 40.

As is evident from FIG. 2, upper electrode blocks 16, 36 of first and third semiconductor laser modules 10, 30 and lower electrode blocks 21, 41 of second and fourth semiconductor laser modules 20, 40 function as negative electrodes, and lower electrode blocks 11, 31 of first and third semiconductor laser modules 10, 30 and upper electrode blocks 26, 46 of second and fourth semiconductor laser modules 20, 40 function as positive electrodes.

[Heat discharge from semiconductor laser device]

When a predetermined positive voltage is applied to bus bar 53 in a state where cooling water flows through flow path 66 in heat dissipation block 60 using a cooling water circulation mechanism (not illustrated), current begins to flow in each of semiconductor laser elements 14, 24, 34, 44 of first to fourth semiconductor laser modules 10, 20, 30, 40. When the current exceeds a predetermined threshold value, laser light is emitted forward from each of first to fourth semiconductor laser modules 10, 20, 30, 40.

At this time, heat generated in each of semiconductor laser elements 14, 24, 34, 44 of first to fourth semiconductor laser modules 10, 20, 30, 40 is mainly discharged outside from two paths. The first heat discharge path is for discharging heat into a surrounding atmosphere from upper electrode blocks 16, 26, 36, 46. The second heat discharge path is for discharging heat into flow path 66 of heat dissipation block 60 from semiconductor laser elements 14, 24, 34, 44 using sub-mounts 13, 23, 33, 43 and lower electrode blocks 11, 21, 31, 41.

Flow path 66 is formed by covering above groove portion 65 formed in lower heat dissipation block 61 with first and second upper heat dissipation blocks 63a, 63b. Insulating sealant 62 interposed between lower heat dissipation block 61, and first and second upper heat dissipation block 53a, 63b, is provided with openings 62a, 62b as described above. That is, first and second upper heat dissipation blocks 63a, 63b have lower surfaces in direct contact with the cooling water flowing through flow path 66, so that first and second upper heat dissipation blocks 53a, 63b are directly cooled by the cooling water. Thus, heat transferred from lower electrode blocks 11, 21, 31, 41 to first and second upper heat dissipation blocks 53a, 63b by heat conduction is promptly discharged outside semiconductor laser device 100 using the cooling water. The cooling water discharged from discharge port 66b is cooled to a predetermined temperature using a coolant circulation mechanism (not illustrated), and then is supplied again from inflow port 66a into flow path 66.

[Effect, etc.]

As described above, semiconductor laser device 100 according to the present exemplary embodiment includes heat dissipation block 60 provided inside with flow path 66 through which cooling water flows, and first to fourth semiconductor laser modules 10, 20, 30, 40 disposed on heat dissipation block 60.

Heat dissipation block 60 includes lower heat dissipation block 61 formed with groove 65 constituting flow path 66, insulating sealant 62 that is disposed in contact with the upper surface of lower heat dissipation block 61 and that has openings 62a and 62b above groove 65, and first and second upper heat dissipation blocks 63a, 63b that are each made of a conductive material and that are disposed in contact with the upper surface of insulating sealant 62, covering openings 62a, 62b, respectively. First upper heat dissipation block 63a and second upper heat dissipation block 63b are provided away from each other at a predetermined interval.

First semiconductor laser module 10 is disposed in contact with the upper surface of first upper heat dissipation block 63a, having a positive electrode side facing down, and second semiconductor laser module 20 is disposed in contact with the upper surface of first upper heat dissipation block 63a, having a negative electrode side facing down. Third semiconductor laser module 30 is disposed in contact with the upper surface of second upper heat dissipation block 63b, having a positive electrode side facing down, and fourth semiconductor laser module 40 is disposed in contact with the upper surface of second upper heat dissipation block 63b, having a negative electrode side facing down. Additionally, a positive electrode side of second semiconductor laser module 20 and a negative electrode side of third semiconductor laser module 30 are electrically connected using bus bar 52.

Forming semiconductor laser device 100 as described above enables first and second upper heat dissipation blocks 63a, 63b that are respectively located above openings 62a, 62b of insulating sealant 62 to be directly cooled by the cooling water, so that heat generated in first to fourth semiconductor laser modules 10, 20, 30, 40 disposed in contact with the corresponding upper surfaces of first and second upper heat dissipation blocks 63a, 63b can be promptly discharged outside semiconductor laser device 100. That is, cooling efficiency of first to fourth semiconductor laser modules 10, 20, 30, 40 can be improved. This also enables increasing the amount of current flowing into semiconductor laser elements 14, 24, 34, 44, so that semiconductor laser device 100 can have a high output. Interposing insulating sealant 62 between first and second upper heat dissipation blocks 63a, 63b, and lower heat dissipation block 61, not only allows first to fourth semiconductor laser modules 10, 20, 30, 40 to be insulated from lower heat dissipation block 61, but also enables cooling water flowing through flow path 66 to be prevented from leaking outside.

Additionally, first upper heat dissipation block 63a can be used as a current path, so that first and second semiconductor laser modules 10, 20 can be connected in series without using a conductive member. Similarly, second upper heat dissipation block 63b can be used as a current path, so that third and fourth semiconductor laser module 30, 40 can be connected in series without using a conductive member. Then, connecting the positive electrode side of second semiconductor laser module 20 and the negative electrode side of third semiconductor laser module 30 using bus bar 52 enables first to fourth semiconductor laser modules 10, 20, 30, 40 to be connected in series.

When a plurality of semiconductor laser modules is connected in parallel to fabricate a high-output semiconductor laser device 100 having a high output, a load on a power supply connected to the semiconductor laser device increases. This requires increase in power supply capacity to cause increase in size of power supply equipment and increase in equipment costs.

The present exemplary embodiment enables suppressing an increase in load on a power supply, so that the power supply can be reduced in size. Additionally, an increase in equipment costs can be suppressed.

When a plurality of semiconductor laser modules is disposed on heat dissipation block 60 while being electrically separated and is connected in series using a conductive member such as a bus bar, the semiconductor laser modules are required to be separated from each other at an interval more than a distance enabling mutual insulation to be secured. However, an attempt to increase output of semiconductor laser device 100 increases also an applied voltage itself, so that semiconductor laser device 100 is increased in size to secure an insulation distance between the semiconductor laser modules. Additionally, many conductive members are required, and increase in thickness of each conductive member is required to reduce electric resistance. This causes an increase in cost. Each conductive member also cannot be reduced in length to a predetermined length or less to secure an insulation distance, so that electric resistance in the entire current path cannot be sufficiently reduced.

In contrast, the present exemplary embodiment allows first semiconductor laser module 10 and second semiconductor laser module 20 to be electrically connected using first upper heat dissipation block 63a, so that an interval for insulation is not required between the semiconductor laser modules. Similarly, using second upper heat dissipation block 63b does not require an interval for insulation between third semiconductor laser module 30 and fourth semiconductor laser module 40. These structures enable suppressing increase in size of semiconductor laser device 100. Additionally, a number of conductive members connecting the semiconductor laser modules can be reduced, so that increase in cost can be suppressed.

First to fourth semiconductor laser modules 10, 20, 30, 40 respectively include: lower electrode blocks 11, 21, 31, 41; sub-mounts 13, 23, 33, 43 that are electrically connected to the corresponding lower electrode blocks; semiconductor laser elements 14, 24, 34, 44 that are disposed on and electrically connected to sub-mounts 13, 23, 33, 43, respectively; and upper electrode blocks 16, 26, 36, 46 that are provided to hold sets of sub-mounts 13, 23, 33, 43 and corresponding semiconductor laser elements 14, 24, 34, 44 with lower electrode blocks 11, 21, 31, 41, respectively, and that are electrically connected to semiconductor laser elements 14, 24, 34, 44, respectively, while being electrically insulated from lower electrode blocks 11, 21, 31, 41, respectively, using insulating sheet 12 interposed therebetween.

Lower electrode blocks 11, 21 of first and second semiconductor laser modules 10, 20 are disposed in contact with the upper surface of first upper heat dissipation block 63a, and lower electrode blocks 31, 41 of third and fourth semiconductor laser modules 30, 40 are disposed in contact with the upper surface of second upper heat dissipation block 63a.

When first to fourth semiconductor laser modules 10, 20, 30, 40 are formed as described above, heat can be promptly discharged outside from semiconductor laser elements 14, 24, 34, 44, which are heat sources, through lower electrode blocks 11, 21, 31, 41, respectively.

Upper electrode blocks 16, 26, 36, 46 of first to fourth semiconductor laser modules 10, 20, 30, 40 are preferably identical in outer shape in top view, and lower electrode blocks 11, 21, 31, 41 of first to fourth semiconductor laser modules 10, 20, 30, 40 are preferably identical in outer shape in top view.

This structure enables electrode blocks having a common shape to be used in first to fourth semiconductor laser modules 10, 20, 30, 40, so that cost can be reduced.

Additionally, upper electrode blocks 16, 26, 36, 46 and lower electrode blocks 11, 21, 31, 41 of first to fourth semiconductor laser modules 10, 20, 30, 40 are preferably identical in outer shape in top view. Each of upper electrode blocks 16, 26, 36, 46 of first to fourth semiconductor laser modules 10, 20, 30, 40 more preferably has a screw hole for fixing a module and a screw hole for fixing a terminal that are identical in position to those in the corresponding one of lower electrode blocks 11, 21, 31, 41 thereof in top view.

As illustrated in FIG. 2, first and third semiconductor laser modules 10, 30 have vertically inverted structures of second and fourth semiconductor laser modules 20, 40. That is, placement of an electrode block formed with a recessed portion is vertically inverted. In this case, when first to fourth semiconductor laser modules 10, 20, 30, 40 respectively have upper electrode blocks 16, 26, 36, 46 that are different in outer shape from lower electrode blocks 11, 21, 31, 41, respectively, the blocks need to be formed separately to cause increase in cost.

In contrast, the present exemplary embodiment allows first to fourth semiconductor laser modules 10, 20, 30, 40 to have upper electrode block 16, 26, 36, 46, respectively, that are identical in outer shape to lower electrode blocks 11, 21, 31, 41, so that the separate production described above and the like are not required to be performed, and thus increase in cost can be suppressed.

Semiconductor laser device 100 according to the present exemplary embodiment is configured such that lower electrode blocks 11, 31 of first and third semiconductor laser modules 10, 30 are formed with recessed portions 11b,31b for accommodating sub-mount 13, 33 and semiconductor laser elements 14, 34, respectively, and that upper electrode blocks 26, 46 of second and fourth semiconductor laser modules 20, 40 are formed with recessed portions 26c, 46c for accommodating sub-mounts 23, 43 and semiconductor laser elements 24, 44, respectively.

These structures enable a position of an electrode block connected to a lower electrode of a semiconductor laser element can be alternately inverted vertically, so that first to fourth semiconductor laser modules 10, 20, 30, 40 can be connected in series with a simple structure.

First to fourth semiconductor laser modules 10, 20, 30, 40 respectively include semiconductor laser elements 14, 24, 34, 44 each having a laser light emitting end surface that is preferably located near flow path 66 of heat dissipation block 60 in top view, and more preferably near a portion of flow path 60 that directly extends from inflow port 66a for cooling water.

During operation of the semiconductor laser element, temperature rises most near the laser light emitting end surface. Thus, when the laser light emitting end surface is disposed near flow path 66 of heat dissipation block 60, particularly near a portion where cooling water directly flows from the inflow port 66a without being heated, first to fourth semiconductor laser modules 10, 20, 30, 40 including semiconductor laser elements 14, 24, 34, 44, respectively, can be improved in cooling efficiency.

The upper surface of first upper heat dissipation block 63a, and lower surfaces of lower electrode blocks 11, 21 of first and second semiconductor laser modules 10, 20, in contact with the upper surface, are preferably flat. The upper surface of second upper heat dissipation block 63b, and lower surfaces of lower electrode blocks 31, 41 of third and fourth semiconductor laser modules 30, 40, in contact with the upper surface, are also preferably flat.

These structures enable increasing a contact area between first upper heat dissipation block 63 and lower electrode blocks 11, 21 of first and second semiconductor laser modules 10, 20, so that first and second semiconductor laser modules 10, 20 can be improved in cooling efficiency. Similarly, a contact area between second upper heat dissipation block 63b and lower electrode blocks 31, 41 of third and fourth semiconductor laser modules 30, 40 can be increased, so that third and fourth semiconductor laser modules 30, 40 can be improved in cooling efficiency.

<First modification>

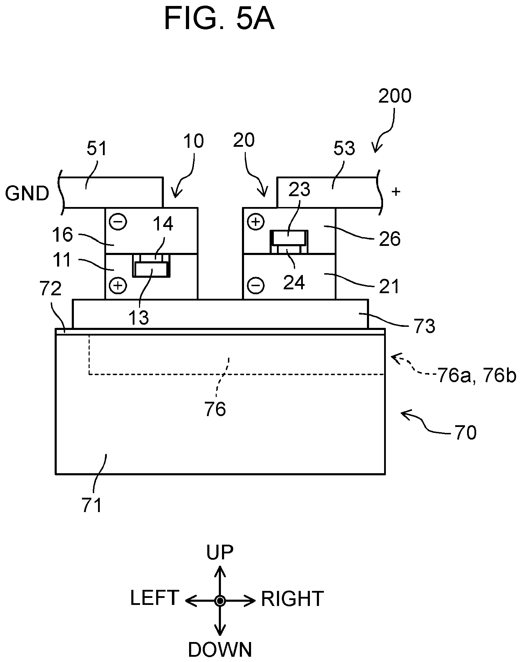

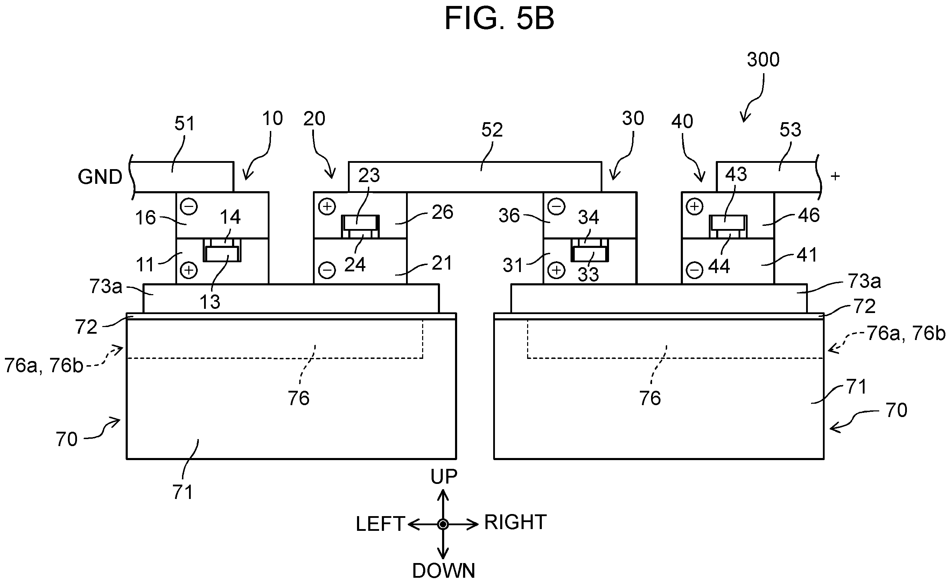

FIGS. 5A and 5B are each a schematic diagram of a front side surface of a semiconductor laser device according to the present modification, and each part of semiconductor laser devices 200, 300 is different in shape, position, placement relationship, and dimensions from actual relationships, as with that illustrated in FIG. 2. Then, details of each part are not illustrated.

A structure shown in the present modification is different from the structure of the first exemplary embodiment illustrated in FIG. 1 in that one heat dissipation block 70 is provided with only two semiconductor laser modules 10, 20 or semiconductor laser modules 30, 40. Thus, the second upper heat dissipation block illustrated in FIGS. 1 to 3 is eliminated in heat dissipation block 70 shown in the present modification, and heat dissipation block 70 includes lower heat dissipation block 71, insulating sealant 72, and first upper heat dissipation block 73. Heat dissipation block 70 is provided inside with flow path 76. Flow path 76 has one end serving as inflow port 76a for cooling water and the other end serving as discharge port 76b for cooling water, as with the structure shown in the first exemplary embodiment. Although not illustrated, insulating sealant 72 is provided with one opening.

Depending on required specifications of laser light output, semiconductor laser device 200 may be configured as illustrated in FIG. 5A. This enables the structure of heat dissipation block 70 to be simplified, so that semiconductor laser device 200 can be reduced is cost.

Instead of the structure illustrated in FIG. 1, semiconductor laser device 300 may be configured as illustrated in FIG. 5B. The structure illustrated in FIG. 5B has more components than the structure illustrated in FIG. 1, so that adjacent heat dissipation blocks 70 need to be appropriately separated from each other.

Then, as described above, when cooling water flowing from inflow port 76a is allowed to directly pass through near a laser light emitting end surface in top view, the semiconductor laser module can be improved in cooling efficiency. Thus, as illustrated in FIG. 5B, when cooling water is allowed to flow independently into heat dissipation block 70 provided with first and second semiconductor laser modules 10, 20, and heat dissipation block 70 provided with third and fourth semiconductor laser modules 30, 40, first to fourth semiconductor laser modules 10, 20, 30, 40 can be more improved in cooling efficiency than those in the structure illustrated FIG. 1.

<Second modification>

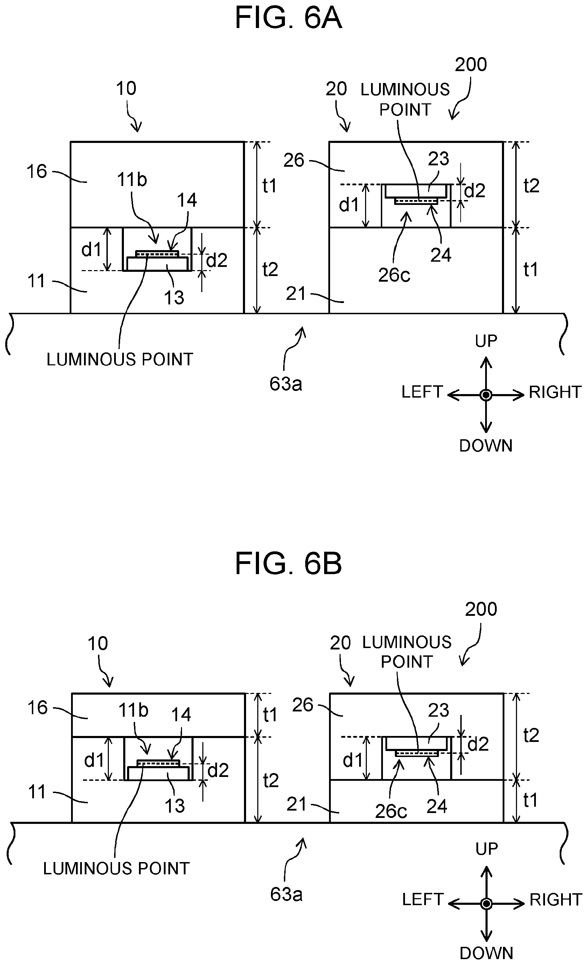

FIG. 6A is a schematic diagram of a front side surface of a semiconductor laser device for comparison. FIG. 6B is a schematic diagram of a front side surface of a semiconductor laser device according to the present modification. Although structures illustrated in FIGS. 6A and 6B are each similar to the structure illustrated in FIG. 5A, a part of the structures including an insulating sealant is not illustrated for convenience of description. Each part of semiconductor laser device 200 is different in shape, position, placement relationship, and dimensions from actual relationships, as with that illustrated in FIG. 2. Then, details of each part are not illustrated. Although for convenience of description, semiconductor laser elements 14, 24 and electrode blocks 16, 21 facing semiconductor laser elements 14, 24, respectively, are illustrated spaced from each other, bumps and metal sheets are actually interposed therebetween. Thus, semiconductor laser element 14 and upper electrode block 16 are in contact with each other. Similarly, semiconductor laser element 24 and lower electrode block 21 are in contact with each other.

When laser light is emitted from each of semiconductor laser elements mounted in a laser device including a single semiconductor laser device or a plurality of semiconductor laser devices disposed side by side, laser light having a higher output can be obtained by optically combining the laser light of each of the semiconductor laser elements into one piece of laser light. The laser light can be optically combined by disposing optical components, such as a light deflecting member that deflects laser light emitted from each semiconductor laser element in a predetermined direction and a condenser lens, at respective predetermined positions.

At this time, when a distance from a reference plane, such as an upper surface of first upper heat dissipation block 63a and/or second upper heat dissipation block 63b, to a luminous point of each semiconductor laser element is equal, a light deflecting member that vertically deflects laser light is not required. This causes structure of the laser device to be simplified, so that costs can be reduced.

With reference to FIGS. 6A and 6B, the upper surface of first upper heat dissipation block 63a is defined as a reference plane. First and second semiconductor laser modules 10, 20 each include an electrode block formed with no recessed portion that has a thickness indicated as t1, an electrode block formed with a recessed portion, including a portion other than the recessed portion that has a thickness indicated as t2, the recessed portion having a depth indicated as d1, a dimension including a thickness of each of sub-mounts 13, 23 and a distance from a bottom surface of each of semiconductor laser elements 14, 24 mounted on sub mount 13, 23, respectively, to a luminous point thereof that is indicated as d2. At this time, distance D1 from the reference plane to the luminous point of first semiconductor laser module 10, distance D2 from the reference plane to the luminous point of the second semiconductor laser module, and "D2 -D1" are represented by Expressions (1) to (3), respectively.

$$D1 = t2 \cdot d1 + d2 \ ... \ (1)$$

$$D2 = t1 + d1 \cdot d2 \ ... \ (2)$$

$$D2 \cdot D1 = (t1 \cdot t2) + 2(d1 \cdot d2) \ ... \ (3)$$

The thickness of each of sub-mounts 13, 23 includes a thickness of an adhesive layer (not illustrated) provided between sub-mounts 13, 23 and semiconductor laser elements 14, 24, respectively. Insulating sheet 12 has a thickness equal in each of first and second semiconductor laser modules 10, 20, so that the thickness of the insulating sheet 12 is not considered in Expressions (1) to (3) for convenience of description.

Here, assuming that t1 = t2, that is, when first and second semiconductor laser modules 10, 20 respectively include upper electrode blocks 16, 26 and lower electrode blocks 11, 21 that are equal in thickness, Expression (4) below holds.

$$D2 \cdot D1 = 2(d1 \cdot d2) \ ... \ (4)$$

As described above, semiconductor laser elements 14, 24 are each formed with bumps 50, so that d1 is more than d2. Thus, first and second semiconductor laser modules 10, 20 each have a different distance from the reference plane to the luminous point. This requires laser light emitted from any one of first semiconductor laser module 10 and second semiconductor laser module 20 to be vertically deflected to optically combine the laser light as described above, so that the laser device has a complex structure to increase costs.

To solve such a problem, as illustrated in FIG. 6B, that is, first and second semiconductor laser modules 10, 20 may respectively include upper electrode block 16 and lower electrode block 21 each having a thickness adjusted to allow the left side of Expression (3) to be zero.

At this time, the following relationship holds.

$$t1 = t2 \cdot 2(d1 \cdot d2) \ ... \ (5)$$

Unfortunately, lower electrode blocks 11, 21 are different from each other in thicknesses in this case, so that heat dissipation efficiency to flow path 66 and to the outside in first semiconductor laser module 10 may be different from heat dissipation efficiency to flow path 66 and to the outside in second semiconductor laser module 20. Thus, whether each semiconductor laser module is caused to be similar in heat dissipation efficiency or caused to have a luminous point identical in position is appropriately selected in accordance with required specifications of the laser device.

As in shown in the first exemplary embodiment, when upper electrode blocks 16, 26 and lower electrode blocks 11, 21 of first and second semiconductor laser modules 10, 20 are formed having an identical outer shape in top view, and upper electrode blocks 16, 26 and lower electrode blocks 11, 21 of first and second semiconductor laser modules 10, 20 are each provided with a screw hole for fixing a module and a screw for fixing a terminal that are each disposed at an identical position in top view, electrode blocks required to be formed separately can be sorted into only two types. It is needless to say that the logic above similarly can apply to third and fourth semiconductor laser modules 30 and 40.

(Second exemplary embodiment)

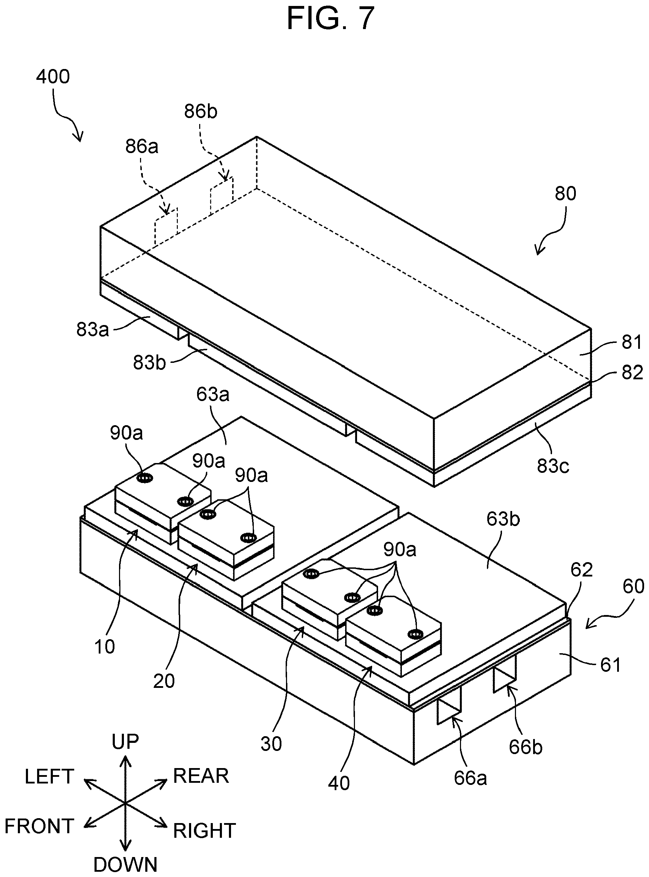

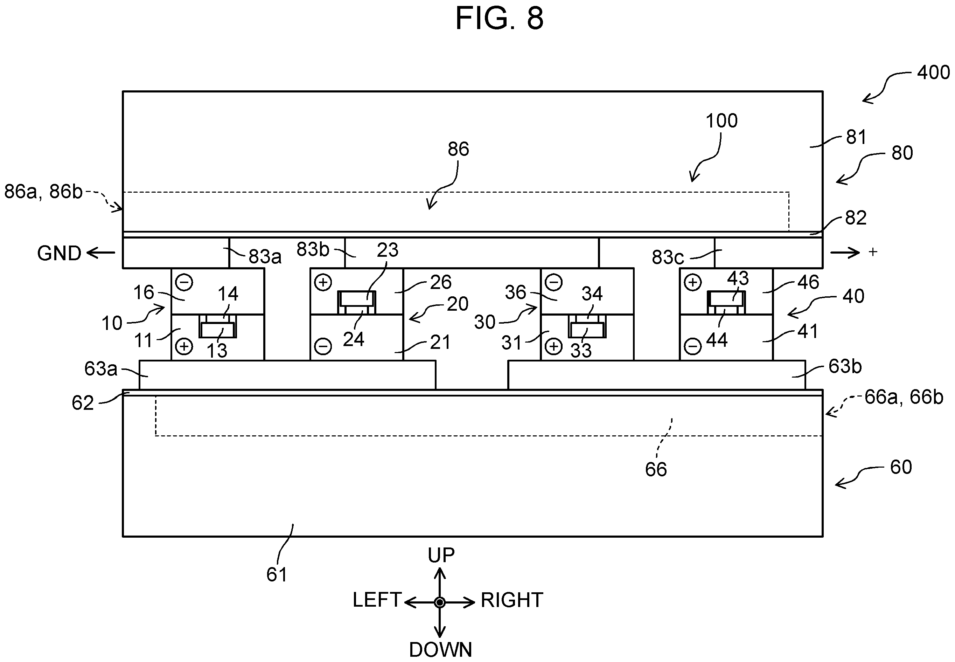

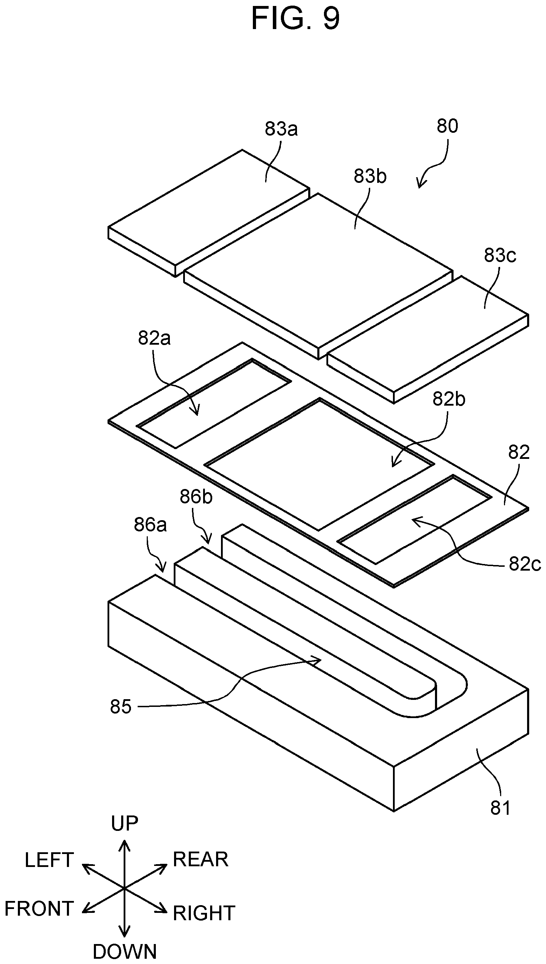

FIG. 7 is an exploded perspective view of a semiconductor laser device according to the present exemplary embodiment, and FIG. 8 is a schematic diagram of a front side surface thereof. FIG. 9 is an exploded perspective view of an additional heat dissipation block. In FIG. 8, each part of semiconductor laser device 400 is different in shape, position, placement relationship, and dimensions from actual relationships, as with that illustrated in FIG. 2. Then, details of each part are not illustrated.

Semiconductor laser device 400 shown in the present exemplary embodiment is different from the structure of first exemplary embodiment illustrated in FIG. 1 in that additional heat dissipation block 80 is disposed on upper surfaces of upper electrode blocks 16, 26, 36, 46 of first to fourth semiconductor laser modules 10, 20, 30, 40.

As described above, the structure illustrated in FIG. 1 allows heat transferred from semiconductor laser elements 14, 24, 34, 44 to upper electrode blocks 16, 26, 36, 46 to be discharged to the outside atmosphere from surfaces of upper electrode blocks 16, 26, 36, 46. However, this heat discharge path has a lower cooling efficiency than a path in which heat generated in semiconductor laser elements 14, 24, 34, 44 is discharged outside using cooling water flowing through flow path 66 of lower electrode blocks 11, 21, 31, 41 and heat dissipation block 60.

In general, a semiconductor laser element has a luminous point closer to an upper electrode (positive electrode) than a lower electrode (negative electrode) (refer to FIGS. 6A and 6B), and temperature rises most near this luminous point during operation of the semiconductor laser element. This causes the semiconductor laser element to be usually mounted having an upper electrode in thermal contact with a sub-mount.

In contrast, for example, second semiconductor laser module 20 and fourth semiconductor laser module 40 include upper electrode blocks 26, 46 provided with sub-mounts 23, 43, respectively, are not in contact with heat dissipation block 60 as illustrated in FIG. 2, and thus cooling efficiency of these semiconductor laser modules cannot be said to be sufficient.

The present exemplary embodiment enables improving this point. This improvement will be described below.

As illustrated in FIG. 9, additional heat dissipation block 80 is different from the structure illustrated in FIGS. 3A and 3B in that insulating sealant 82 is provided with three openings 82a to 82c, and third to fifth upper electrode blocks 83a to 83c are provided covering openings 82a to 82c, respectively. The structure except this, including material, is similar to that of heat dissipation block 60. For example, groove 85 constituting flow path 86 has a U-shape in top view (refer to FIG. 9). As with the structure shown in the first exemplary embodiment, all of three openings 82a to 82c pass through insulating sealant 82 in its thickness direction. Heat dissipation block 80 is disposed on upper surfaces of respective semiconductor laser modules 10, 20, 30, 40, and thus a head of module fixing screw 90a is located flush with upper surfaces of respective upper electrode blocks 16, 26, 36, 46, or below the upper surfaces. Then, no terminal fixing screw 91 is provided.

Although a placement direction is different from an actual placement direction in vertical relationships, additional heat dissipation block 80 includes members disposed on upper surfaces of upper electrode blocks 16, 26, 36, 46 of first to fourth semiconductor laser modules 10, 20, 30, 40, being referred to as third to fifth upper heat dissipation blocks 83a to 83c, and a block formed with groove 85 constituting flow path 86, being referred to as lower heat dissipation block 81. Thus, upper surfaces of third to fifth upper heat dissipation blocks 83a to 83c of additional heat dissipation block 80 are in direct contact with cooling water flowing through flow path 86.

The present exemplary embodiment enables heat transferred from semiconductor laser elements 14, 24, 34, 44 to upper electrode blocks 16, 26, 36, 46 of semiconductor laser modules 10, 20, 30, 40, respectively, to be efficiently discharged outside using third to fifth upper heat dissipation blocks 83a to 83c and cooling water flowing through flow path 86. This also enables increasing the amount of current flowing into semiconductor laser elements 14, 24, 34, 44, so that semiconductor laser device 400 can have a higher output.

The present exemplary embodiment also enables bus bars 51 to 53 illustrated in FIG. 1 to be eliminated. As illustrated in FIG. 8, fourth upper heat dissipation block 83b of additional heat dissipation block 80 is disposed in contact with upper surfaces of upper electrode blocks 26, 36 of second and third semiconductor laser modules 20, 30, and has a function similar to that of bus bar 52 illustrated in FIG. 1, that is, the function of electrically connecting second semiconductor laser module 20 and third semiconductor laser module 30.

When semiconductor laser device 400 is configured as described above, a number of components to be mounted can be reduced, and component costs and assembly costs can be reduced, as compared with the structure illustrated in FIG. 1. First to fourth semiconductor laser modules 10, 20, 30, 40 also can be connected in series with a simple structure. In this case, third upper heat dissipation block 83a is electrically connected to a power supply terminal (not illustrated) having a ground potential, and fifth upper heat dissipation block 83c is electrically connected to a power supply terminal (not illustrated) having a positive potential.

additional heat dissipation block 80 of the present exemplary embodiment includes inflow port 86a for cooling water, provided on a left side surface and a front side, and discharge port 86b provided on the left side surface and behind inflow port 86a at a predetermined distance from inflow port 86a. That is, additional heat dissipation block 80 has a structure in which placement of the inflow port and the discharge port in heat dissipation block 60 disposed on lower surfaces of respective first to fourth semiconductor laser modules 10, 20, 30, 40 is laterally inverted.

The cooling water flowing into flow path 66 from inflow port 66a of heat dissipation block 60 gradually increases in temperature as it sequentially passes through below first to fourth semiconductor laser modules 10, 20, 30, 40, due to inflowing heat. Similarly, the cooling water gradually increases in temperature also in additional heat dissipation block 80, as it sequentially passes through above first to fourth semiconductor laser modules 10, 20, 30, 40, due to inflowing heat. In this case, when the cooling water flowing from inflow port 66a of heat dissipation block 60 and the cooling water flowing from inflow port 86a of additional heat dissipation block 80 flow in the same direction, a semiconductor laser module near the inflow ports and a semiconductor far from the inflow ports are different in cooling efficiency. When such a state continues in semiconductor laser device 400 during usage for a long period of time, each semiconductor laser module differs in a degree of deterioration. As a result, the life of the semiconductor laser device 400 may be shortened.

In contrast, the present exemplary embodiment enables suppressing reduction in life of semiconductor laser device 400 by allowing a flowing direction of the cooling water flowing through below first to fourth semiconductor laser modules 10, 20, 30, 40 and a flowing direction of the cooling water flowing through above first to fourth semiconductor laser modules 10, 20, 30, 40 to be opposite to each other, for example, by reducing a difference in cooling efficiency between first semiconductor laser module 10 located at a left end of four semiconductor laser modules 10, 20, 30, 40 disposed side by side and fourth semiconductor laser module 40 located at a right end thereof in the structure illustrated in FIGS. 7 and 8.

(Other exemplary embodiments)

Although the first and second exemplary embodiments each show an example in which four semiconductor laser modules 10, 20, 30, 40 are disposed on identical heat dissipation block 60, the present invention is not particularly limited to this, and an even number of semiconductor laser modules may be disposed on the identical heat dissipation block. However, that case requires two semiconductor laser modules to be disposed on each upper heat dissipation block and the semiconductor laser modules to be insulated by spacing adjacent upper heat dissipation blocks at a predetermined distance or more. When additional heat dissipation block 80 is disposed above the semiconductor laser modules, n (n is an even number of four or more) semiconductor laser modules are disposed on identical heat dissipation block 60.

The structure illustrated in FIG. 1 may include a metal layer (not illustrated) on lower surfaces of upper electrode blocks 16, 36 of first and third semiconductor laser modules 10, 30, at positions covering recessed portions 11b, 31b. The metal layer provided in this manner is brought into contact with a metal sheet to allow bumps 50 and upper electrode blocks 16, 36 to be electrically connected to each other, and surrounds side surfaces of bumps 50 to enable reducing contact resistance between bumps 50 and upper electrode blocks 16, 36. Although the metal layer is preferably made of gold, other conductive materials may be used. However, hardness or the like of the metal layer needs to be considered to prevent bumps 50 from being greatly deformed or removed when upper electrode blocks 16 and 36 are attached to lower electrode blocks 21, 31, respectively. Similarly, metal layers may be provided on respective upper surfaces of lower electrode blocks 21, 41 of second and fourth semiconductor laser modules 20, 40, at respective positions facing recessed portion 16c, 36c of upper electrode blocks 16, 36 of first and third semiconductor laser modules 10, 30. The same effect as described above can be obtained.

Although an example in which cooling water is used as a coolant is shown, a coolant other than water, such as an antifreeze liquid, may be used. When the semiconductor laser element is excessively cooled, for example, cooled to several degrees Celsius, dew condensation may occur on a laser light emitting end surface, for example. When such dew condensation occurs, laser oscillation may not occur or the semiconductor laser device may be damaged in some cases. When temperature of the semiconductor laser element greatly exceeds 60°C, light output characteristics may change, and thus desired output may not be obtained. Thus, it is preferable to select a kind of coolant or to control temperature of the coolant such that the semiconductor laser element in operation can be maintained at a temperature of about 10°C to 40°C.

Lower surfaces of first and second upper heat dissipation blocks 63a, 63b may be covered with an insulating material. Similarly, lower surfaces of third to fifth upper heat dissipation blocks 83a to 83c (surfaces constituting one surface of a flow path) also may be covered with an insulating material.

When cooling water is used for a long period of time, resistivity of the cooling water may be reduced due to impurities eluted from pipes (not illustrated), etc., and thus electric leakage through the cooling water may not be successfully prevented. Depending on a kind of coolant, the resistivity may not be increased above a desired value.

In such a case, when surfaces of first to fifth upper heat dissipation blocks 63a, 63b, 83a to 83c, with which a coolant such as cooling water is directly brought into contact, are covered with an insulating material as described above, electric leakage though the coolant can be prevented from occurring. To prevent deterioration in thermal discharge efficiency from first to fifth upper heat dissipation blocks 63a, 63b, 83a to 83c to the coolant, thermal conductivity and thickness of the insulating material need to be set appropriately.

The exemplary embodiments described above including the modifications may be different in shape of the upper electrode block and the lower electrode block, for example, in outer shape in top view.

Besides this, each component described in each of the exemplary embodiments and modifications described above may be combined to form an additional exemplary embodiment.

INDUSTRIAL APPLICABILITY

The semiconductor laser device according to the present invention can improve cooling efficiency of a semiconductor laser module mounted thereon and is useful when applied to a laser light source of a laser processing device or the like.

REFERENCE MARKS IN THE DRAWINGS

10 first semiconductor laser module
11 lower electrode block
11a screw hole
11b screw hole
12 insulating sheet
12a opening
13 sub-mount
14 semiconductor laser element
15 bumps
16 upper electrode block
16a screw hole
16b screw hole
20 second semiconductor laser module
21 lower electrode block
23 sub-mount
24 semiconductor laser element

26 upper electrode block
26c recessed portion
30 third semiconductor laser module
31 lower electrode block
31b recessed portion
33 sub-mount
34 semiconductor laser element
36 upper electrode block
40 fourth semiconductor laser module
41 lower electrode block
43 sub-mount
44 semiconductor laser element
46 upper electrode block
46c recessed portion
51 to 53 bus bar
60, 70 heat dissipation block
61, 71 lower heat dissipation block
62, 72 insulating sealant
62a, 62b opening
63a, 73a first upper heat dissipation block
63b second upper heat dissipation block
64 screw hole
65 groove
66, 76 flow path
66a, 76a inflow port
66b, 76b discharge port
80 additional heat dissipation block
81 lower heat dissipation block
82 insulating sealant
82a to 82c opening
83a third upper heat dissipation block
83b fourth upper heat dissipation block
83c fifth upper heat dissipation block
90, 90a module fixing screw
91 terminal fixing screw
100, 200, 300, 400 semiconductor laser device

**Claims**

1. A semiconductor laser device (100 200 300 400) at least comprising:

   a heat dissipation block (60 70) provided inside with a flow path (66 76) through which a coolant flows; and
   a first (10) semiconductor laser module and a second (20) semiconductor laser module disposed on
   the heat dissipation block (60 70),
   the heat dissipation block (60 70) including:

   a lower heat dissipation block (61 71) formed with a groove (65) constituting the flow path (66 76);
   an insulating sealant (62 72) disposed in contact with an upper surface of the lower heat dissipation block (61 71), having an opening above the groove (65); and

   an upper heat dissipation block (63a 63b 73 73a) made of an electrically conductive material disposed in contact with an upper surface of the insulating sealant (62 72), covering the opening, the first (10) semiconductor laser module being disposed in contact with an upper surface of the upper heat dissipation block (63a 63b 73 73a), having a positive electrode side facing down and in electrical contact with the upper heat dissipation block;
   the second (20) semiconductor laser module being disposed in contact with the upper surface of the upper heat dissipation block (63a 63b 73 73a), having a negative electrode side facing down and in electrical contact with the upper heat dissipation block.

2. The semiconductor laser device (100 200 300 400) according to claim 1, wherein

   the first (10) and second (20) semiconductor laser modules (10 20 30 40) each include a lower electrode block (11 21 31 41), a sub-mount (13 23 33 43) that is electrically connected to the lower electrode block (11 21 31 41), a semiconductor laser element (14 24 34 44) that is disposed on the sub-mount (13 23 33 43) and is electrically connected to the sub-mount (13 23 33 43) and the lower electrode block (11 21 31 41), and an upper electrode block (16 26 36 46) that is provided holding the sub-mount (13 23 33 43) and the semiconductor laser element (14 24 34 44) with the lower electrode block (11 21 31 41) and that is electrically connected to the semiconductor laser element (14 24 34 44) while being electrically insulated from the lower electrode block (11 21 31 41) using an insulating layer (12), and
   the lower electrode block (11 21 31 41) of each of the first (10) and second (20) semiconductor laser modules (10 20 30 40) is disposed in contact with the upper surface of the upper heat dissipation block (63a 63b 73 73a).

3. The semiconductor laser device (100 200 300 400) according to claim 2, wherein an additional heat dissipation block (80) is disposed in contact with the upper surface of the upper electrode block (16 26 36 46) of each of the first (10) and second (20) semiconductor laser modules (10 20 30 40).

4. The semiconductor laser device (100 200 300 400) according to claim 3, wherein

   the additional heat dissipation block (80) includes a lower heat dissipation block (81) formed with a groove (85) constituting a flow path (86) through which a coolant flows, an insulating sealant (82) disposed in contact with an upper surface of the lower heat dissipation block (81), having an opening above the groove (85), and an upper heat dissipation block (83a 83b 83c) disposed in contact with an upper surface of the insulating sealant (82), covering the opening, and

the additional heat dissipation block is disposed with an upper surface of the upper heat dissipation block (83a 83b 83c), in contact with the upper surface of the upper electrode block (16 26 36 46) of each of the first (10) and second (20) semiconductor laser modules (10 20 30 40).

5. The semiconductor laser device (100 200 300 400) according to any one of claims 2 to 4, wherein

the upper electrode block (16 26 36 46) of the first (10) semiconductor laser module and the upper electrode block (16 26 36 46) of the second (20) semiconductor laser module are identical in outer shape in top view, and

the upper electrode block (16 26 36 46) of the first (10) semiconductor laser module and the lower electrode block (11 21 31 41) of the second (20) semiconductor laser module are identical in outer shape in top view.

6. The semiconductor laser device (100 200 300 400) according to claim 5, wherein the upper electrode block (16 26 36 46) and the lower electrode block (11 21 31 41) in each of the first (10) and second (20) semiconductor laser modules (10 20 30 40) are identical in outer shape in top view.

7. The semiconductor laser device (100 200 300 400) according to any one of claims 2 to 6, wherein

the lower electrode block (11 21 31 41) of the first (10) semiconductor laser module is formed with a recessed portion (11b 26c 31b 46c) for accommodating the sub-mount (13 23 33 43) and the semiconductor laser element (14 24 34 44), and

the upper electrode block (16 26 36 46) of the second (20) semiconductor laser module is formed with a recessed portion (11b 26c 31b 46c) for accommodating the sub-mount (13 23 33 43) and the semiconductor laser element (14 24 34 44).

8. The semiconductor laser device (100 200 300 400) according to claim 2, further comprising:

third (30) and fourth semiconductor laser modules (10 20 30 40) disposed on the heat dissipation block (60 70), wherein

the heat dissipation block (60 70) at least includes the lower heat dissipation block (61 71), an insulating sealant (62 72) that is disposed in contact with the upper surface of the lower heat dissipation block (61 71), having at least two openings formed above the groove (65) at an interval, and first (63a) and second (63b) upper heat dissipation blocks (63a 63b 73 73a) disposed in contact with an upper surface of the insulating sealant (62 72) at an interval, covering the corresponding two openings,

the first (63a) and second (63b) upper heat dissipation blocks (63a 63b 73 73a) are each made of an electrically conductive material,

the first (10) semiconductor laser module is disposed in contact with an upper surface of the first upper heat dissipation block (63a), having a positive electrode side facing down and in electrical contact with the first upper heat dissipation block,

and the second (20) semiconductor laser module is disposed in contact with the upper surface of the first upper heat dissipation block (63a), having a negative electrode side facing down and in electrical contact with the first upper heat dissipation block;

the third (30) semiconductor laser module is disposed in contact with an upper surface of the second upper heat dissipation block (63b), having a positive electrode side facing down and in electrical contact with the second upper heat dissipation block, and the fourth (40) semiconductor laser module is disposed in contact with the upper surface of the second upper heat dissipation block (63b), having a negative electrode side facing down and in electrical contact with the second upper heat dissipation block; and

the positive electrode side of the second (20) semiconductor laser module and the negative electrode side of the third (30) semiconductor laser module are electrically connected using a conductive member.

9. The semiconductor laser device (100 200 300 400) according to claim 8, wherein

The third (30) and fourth (40) semiconductor laser modules (10 20 30 40) each include a lower electrode block (11 21 31 41), a sub-mount (13 23 33 43) that is electrically connected to the lower electrode block (11 21 31 41), a semiconductor laser element (14 24 34 44) that is disposed on the sub-mount (13 23 33 43) and electrically connected to the sub-mount (13 23 33 43) and the lower electrode block (11 21 31 41), and an upper electrode block (16 26 36 46) that is provided holding the sub-mount (13 23 33 43) and the semiconductor laser element (14 24 34 44) with the lower electrode block (11 21 31 41) and is electrically connected to the semiconductor laser element (14 24 34 44) while being electrically insulated from the lower electrode block (1121 31 41) using an insulating layer (12), the lower electrode block (1121 31 41) of each of the first (10) and second (20) semiconductor laser modules (10 20 30 40) is disposed in contact with the upper surface of the first upper heat dissipation block (63a), and the lower electrode block (11213141) of each of the third (30) and fourth (40) semiconductor laser modules (10 20 30 40) is disposed in contact with the upper surface of the second upper heat dissipation block (63b).

10. The semiconductor laser device (100 200 300 400) according to claim 9, further comprising an additional heat dissipation block (80) that is disposed in contact with an upper surface of the upper electrode block (16 26 36 46) of each of the first (10) to fourth (40) semiconductor laser modules (10 20 30 40).

11. The semiconductor laser device (100 200 300 400) according to claim 10, wherein

the additional heat dissipation block (80) includes a lower heat dissipation block (81) formed with a groove (85) constituting a flow path (86) through which a coolant flows, an insulating sealant (82) that is disposed in contact with an upper surface of the lower heat dissipation block (81) and has at least three openings formed above the groove (85) at intervals, and third to fifth upper electrically conductive heat dissipation blocks (83a 83b 83c) that are disposed in contact with an upper surface of the insulating sealant (82) at intervals, covering the corresponding three openings,
the additional heat dissipation block (80) is disposed on the upper surface of the upper electrode block (16 26 36 46) of each of the first (10) to fourth (40) semiconductor laser modules (10 20 30 40), having an upper surface of each of the third to fifth upper heat dissipation blocks (83a 83b 83c), facing down,
the upper surface of the third upper heat dissipation block (83a) is in contact with the upper surface of the upper electrode block (16 26 36 46) of the first (10) semiconductor laser module,
the upper surface of the fourth upper heat dissipation block (83b) is in contact with the upper surface of the upper electrode block (16 26 36 46) of each of the second (20) and third (30) semiconductor laser modules (10 20 30 40), wherein the fourth upper heat dissipation block (83b) is said conductive member, and
the upper surface of the fifth upper heat dissipation block (83c) is in contact with the upper surface of the upper electrode block (16 26 36 46) of the fourth (40) semiconductor laser module.

12. The semiconductor laser device (100 200 300 400) according to claim 11, wherein the additional heat dissipation block (80) includes an inflow port and a discharge port for a coolant that are provided on a side opposite to an inflow port and a discharge port for a coolant provided in the heat dissipation block (60 70) in top view.

13. The semiconductor laser device (100 200 300 400) according to any one of claims 8 to 12, wherein

the upper electrode block (16 26 36 46) of each of the first (10) to fourth (40) semiconductor laser modules (10 20 30 40) is identical in outer shape in top view, and
the lower electrode block (11 21 31 41) of each of the first (10) to fourth (40) semiconductor laser modules (10 20 30 40) is identical in outer shape in top view.

14. The semiconductor laser device (100 200 300 400) according to claim 13, wherein the upper electrode block (16 26 36 46) of each of the first (10) to fourth (40) semiconductor laser modules (10 20 30 40) and the lower electrode block (11 21 31 41) of each of the first (10) to fourth (40) semiconductor laser modules (10 20 30 40) are identical in outer shape in top view.

15. The semiconductor laser device (100 200 300 400) according to any one of claims 8 to 14, wherein

the lower electrode block (11 21 31 41) of each of the first (10) and third (30) semiconductor laser modules (10 20 30 40) is formed with a recessed portion (11b 26c 31b 46c) for accommodating the sub-mount (13 23 33 43) and the semiconductor laser element (14 24 34 44), and
the upper electrode block (16 26 36 46) of each of the second (20) and fourth (40) semiconductor laser modules (10 20 30 40) is formed with a recessed portion (11b 26c 31b 46c) for accommodating the sub-mount (13 23 33 43) and the semiconductor laser element (14 24 34 44).

**Patentansprüche**

1. Halbleiterlaservorrichtung (100, 200, 300, 400), die mindestens umfasst:

einen Wärmeableitungsblock (60, 70), der im Inneren mit einem Strömungsweg (66, 76) versehen ist, durch den ein Kühlmittel strömt; und ein erstes (10) Halbleiterlasermodul und ein zweites (20) Halbleiterlasermodul, die an dem Wärmeableitungsblock (60 70) angeordnet sind,

wobei der Wärmeableitungsblock (60, 70) umfasst:

einen unteren Wärmeableitungsblock (61, 71), der mit einer Rille (65) gebildet ist, die den Strömungsweg (66, 76) bildet; ein isolierendes Dichtungsmittel (62, 72), das mit einer oberen Oberfläche des unteren Wärmeableitungsblocks (61, 71) in Kontakt angeordnet ist und eine Öffnung über der Rille (65) aufweist; und einen oberen Wärmeableitungsblock (63a, 63b, 73, 73a), der aus einem elektrisch leitfähigen Material besteht, das in Kontakt mit einer oberen Oberfläche des isolierenden Dichtungsmittels (62, 72) angeordnet ist und die Öffnung bedeckt,

wobei das erste (10) Halbleiterlasermodul in Kontakt mit einer oberen Oberfläche des oberen Wärmeableitungsblocks (63a, 63b, 73, 73a) angeordnet ist und eine Positivelektrodenseite aufweist, die nach unten gerichtet ist und in elektrischem Kontakt mit dem oberen Wärmeableitungsblock steht; wobei das zweite (20) Halbleiterlasermodul in Kontakt mit der oberen Oberfläche des oberen Wärmeableitungsblocks (63a, 63b, 73, 73a) angeordnet ist und eine Negativelektrodenseite aufweist, die nach unten gerichtet ist und in elektrischem Kontakt mit dem oberen Wärmeableitungsblock steht.

2. Halbleiterlaservorrichtung (100, 200, 300, 400) nach Anspruch 1, wobei

das erste (10) und das zweite (20) Halbleiterlasermodul (10, 20, 30, 40) jeweils einen unteren Elektrodenblock (11, 21, 31, 41), ein Submount (13, 23, 33, 43), das elektrisch mit dem unteren Elektrodenblock (11, 21, 31, 41) verbunden ist, ein Halbleiterlaserelement (14, 24, 34, 44), das an dem Submount (13, 23, 33, 43) angeordnet ist und elektrisch mit dem Submount (13, 23, 33, 43) und dem unteren Elektrodenblock (11, 21, 31, 41) verbunden ist, und einen oberen Elektrodenblock (16, 26, 36, 46) umfassen, der das Submount (13, 23, 33, 43) und das Halbleiterelement (14, 24, 34, 44) mit dem unteren Elektrodenblock (11, 21, 31, 41) haltend bereitgestellt ist und der elektrisch mit dem Halbleiterlaserelement (14, 24, 34, 44) verbunden ist und dabei elektrisch von dem unteren Elektrodenblock (11, 21, 31, 41) unter Verwendung einer isolierenden Schicht (12) isoliert ist, und der untere Elektrodenblock (11, 21, 31, 41) von jedem von dem ersten (10) und dem zweiten (20) Halbleiterlasermodul (10, 20, 30, 40) in Kontakt mit der oberen Oberfläche des oberen Wärmeableitungsblocks (63a, 63b, 73, 73a) angeordnet ist.

3. Halbleiterlaservorrichtung (100, 200, 300, 400) nach Anspruch 2, wobei ein zusätzlicher Wärmeableitungsblock (80) in Kontakt mit der oberen Oberfläche des oberen Elektrodenblocks (16, 26, 36, 46) von jedem von dem ersten (10) und dem zweiten (20) Halbleiterlasermodul (10, 20, 30, 40) angeordnet ist.

4. Halbleiterlaservorrichtung (100, 200, 300, 400) nach Anspruch 3, wobei

der zusätzliche Wärmeableitungsblock (80) einen unteren Wärmeableitungsblock (81), der mit einer Rille (85) gebildet ist, die einen Strömungsweg (86) bildet, durch den ein Kühlmittel strömt, ein isolierendes Dichtungsmittel (82), das in Kontakt mit einer oberen Oberfläche des unteren Wärmeableitungsblocks (81) angeordnet ist und eine Öffnung über der Rille (85) aufweist, und einen oberen Wärmeableitungsblock (83a, 83b, 83c) umfasst, der in Kontakt mit einer oberen Oberfläche des isolierenden Dichtungsmittels (82) angeordnet ist und die Öffnung bedeckt, und der zusätzliche Wärmeableitungsblock mit einer oberen Oberfläche des oberen Wärmeableitungsblocks (83a, 83b, 83c) in Kontakt mit der oberen Oberfläche des oberen Elektrodenblocks (16, 26, 36, 46) von jedem von dem ersten (10) und dem zweiten (20) Halbleiterlasermodul (10, 20, 30, 40) angeordnet ist.

5. Halbleiterlaservorrichtung (100, 200, 300, 400) nach einem der Ansprüche 2 bis 4, wobei

der obere Elektrodenblock (16, 26, 36, 46) des ersten (10) Halbleiterlasermoduls und der obere Elektrodenblock (16, 26, 36, 46) des zweiten (20) Halbleiterlasermoduls in der Draufsicht in ihrer äußeren Form identisch sind, und der obere Elektrodenblock (16, 26, 36, 46) des ersten (10) Halbleiterlasermoduls und der untere Elektrodenblock (11, 21, 31, 41) des zweiten (20) Halbleiterlasermoduls in der Draufsicht in ihrer äußeren Form identisch sind.

6. Halbleiterlaservorrichtung (100, 200, 300, 400) nach Anspruch 5, wobei der obere Elektrodenblock (16, 26, 36, 46) und der untere Elektrodenblock (11, 21, 31, 41) in jedem von dem ersten (10) und zweiten (20) Halbleiterlasermodul (10, 20, 30, 40) in der Draufsicht in ihrer äußeren Form identisch sind.

7. Halbleiterlaservorrichtung (100, 200, 300, 400) nach einem der Ansprüche 2 bis 6, wobei

der untere Elektrodenblock (11, 21, 31, 41) des ersten (10) Halbleiterlasermoduls mit einem vertieften Abschnitt (11b, 26c, 31b, 46c) zum Aufnehmen des Submounts (13, 23, 33, 43) und des Halbleiterlaserelements (14, 24, 34, 44) gebildet ist, und

der obere Elektrodenblock (16, 26, 36, 46) des zweiten (20) Halbleiterlasermoduls mit einem vertieften Abschnitt (11b, 26c, 31b, 46c) zum Aufnehmen des Submounts (13, 23, 33, 43) und des Halbleiterlaserelements (14, 24, 34, 44) gebildet ist.

8. Halbleiterlaservorrichtung (100, 200, 300, 400) nach Anspruch 2, das ferner umfasst:

ein drittes (30) und ein viertes Halbleiterlasermodul (10, 20, 30, 40), die an dem Wärmeableitungsblock (60, 70) angeordnet sind, wobei

der Wärmeableitungsblock (60, 70) mindestens den unteren Wärmeableitungsblock (61, 71), ein isolierendes Dichtungsmittel (62, 72), das in Kontakt mit der oberen Oberfläche des unteren Wärmeableitungsblocks (61, 71) angeordnet ist und mindestens zwei Öffnungen aufweist, die über der Rille (65) in einem Intervall gebildet sind, und einen ersten (63a) und einen zweiten (63b) oberen Wärmeableitungsblock (63a, 63b, 73, 73a) umfasst, die in Kontakt mit einer oberen Oberfläche des isolierenden Dichtungsmittels (62, 72) in einem Intervall angeordnet sind und die entsprechenden zwei Öffnungen bedecken, wobei der erste (63a) und der zweite (63b) obere Wärmeableitungsblock (63a, 63b, 73, 73a) jeweils aus einem elektrisch leitfähigen Material bestehen,

das erste (10) Halbleiterlasermodul in Kontakt mit einer oberen Oberfläche des ersten oberen Wärmeableitungsblocks (63a) angeordnet ist und eine Positivelektrodenseite aufweist, die nach unten gerichtet ist und in elektrischem Kontakt mit dem ersten oberen Wärmeableitungsblock steht,

und das zweite (20) Halbleiterlasermodul mit der oberen Oberfläche des ersten oberen Wärmeableitungsblocks (63a) in Kontakt steht und eine Negativelektrodenseite aufweist, die nach unten gerichtet ist und in elektrischem Kontakt mit dem ersten oberen Wärmeableitungsblock steht;

das dritte (30) Halbleiterlasermodul mit einer oberen Oberfläche des zweiten oberen Wärmeableitungsblocks (63b) in Kontakt angeordnet ist und eine Positivelektrodenseite aufweist, die nach unten gerichtet ist und in elektrischem Kontakt mit dem zweiten oberen Wärmeableitungsblock steht,

und das vierte (40) Halbleiterlasermodul mit der oberen Oberfläche des zweiten oberen Wärmeableitungsblocks (63b) in Kontakt steht und eine Negativelektrodenseite aufweist, die nach unten gerichtet ist und in elektrischem Kontakt mit dem zweiten oberen Wärmeableitungsblock steht; und

die Positivelektrodenseite des zweiten (20) Halbleiterlasermoduls und die Negativelektrodenseite des dritten (30) Halbleiterlasermoduls unter Verwendung eines leitfähigen Elements elektrisch verbunden sind.

9. Halbleiterlaservorrichtung (100, 200, 300, 400) nach Anspruch 8, wobei

das dritte (30) und das vierte (40) Halbleiterlasermodul (10, 20, 30, 40) jeweils einen unteren Elektrodenblock (11, 21, 31, 41), ein Submount (13, 23, 33, 43), das elektrisch mit dem unteren Elektrodenblock (11, 21, 31, 41) verbunden ist, ein Halbleiterlaserelement (14, 24, 34, 44), das an dem Submount (13, 23, 33, 43) angeordnet ist und elektrisch mit dem Submount (13, 23, 33, 43) und dem unteren Elektrodenblock (11, 21, 31, 41) verbunden ist, und einen oberen Elektrodenblock (16, 26, 36, 46) umfasst, der das Submount (13, 23, 33, 43) und das Halbleiterlaserelement (14, 24, 34, 44) mit dem unteren Elektrodenblock (11, 21, 31, 41) haltend bereitgestellt ist und elektrisch mit dem Halbleiterlaserelement (14, 24, 34, 44) verbunden ist und dabei elektrisch von dem unteren Elektrodenblock (11, 21, 31, 41) unter Verwendung einer isolierenden Schicht (12) isoliert ist,

der untere Elektrodenblock (11, 21, 31, 41) von jedem von dem ersten (10) und dem zweiten (20) Halbleiterlasermodul (10, 20, 30, 40) in Kontakt mit der oberen Oberfläche des ersten oberen Wärmeableitungsblocks (63a) angeordnet ist, und

der untere Elektrodenblock (11, 21, 31, 41) von jedem von dem dritten (30) und vierten (40) Halbleiterlasermodul (10, 20, 30, 40) in Kontakt mit der oberen Oberfläche des zweiten oberen Wärmeableitungsblocks (63b) angeordnet ist.

10. Halbleiterlaservorrichtung (100, 200, 300, 400) nach Anspruch 9, die ferner einen zusätzlichen Wärmeableitungsblock (80) umfasst, der in Kontakt mit einer oberen Oberfläche des oberen Elektrodenblocks (16, 26, 36, 46) von jedem von dem ersten (10) bis vierten (40) Halbleiterlasermodul (10, 20, 30, 40) angeordnet ist.

11. Halbleiterlaservorrichtung (100, 200, 300, 400) nach Anspruch 10, wobei

der zusätzliche Wärmeableitungsblock (80) einen unteren Wärmeableitungsblock (81), der mit einer Rille (85) gebildet ist, die einen Strömungsweg (86) bildet, durch den ein Kühlmittel strömt, ein isolierendes Dichtungsmittel (82), das in Kontakt mit einer oberen Oberfläche des unteren Wärmeableitungsblocks (81) angeordnet ist und mindestens drei Öffnungen aufweist, die in Intervallen über der Rille (85) gebildet sind, und einen dritten bis fünften oberen elektrisch leitfähigen Wärmeableitungsblock (83a, 83b, 83c) umfasst, die in Kontakt mit einer oberen Oberfläche des isolierenden Dichtungsmittels (82) in Intervallen angeordnet sind und die entsprechenden drei Öffnungen bedecken, der zusätzliche Wärmeableitungsblock (80) an der oberen Oberfläche des oberen Elektrodenblocks (16, 26, 36, 46) von jedem von dem ersten (10) bis vierten (40) Halbleiterlasermodul (10, 20, 30, 40) angeordnet ist und eine obere Oberfläche von jedem von dem ersten bis fünften oberen Wärmeableitungsblock (83a, 83b, 83c) aufweist, die nach unten gerichtet ist, wobei die obere Oberfläche des dritten oberen Wärmeübertragungsblocks (83a) in Kontakt mit der oberen Oberfläche des oberen Elektrodenblocks (16, 26, 36, 46) des ersten (10) Halbleiterlasermoduls steht, die obere Oberfläche des vierten oberen Wärmeübertragungsblocks (83b) in Kontakt mit der oberen Oberfläche des oberen Elektrodenblocks (16, 26, 36, 46) von jedem von dem zweiten (20) und dritten (30) Halbleiterlasermodul (10, 20, 30, 40) steht, wobei der vierte obere Wärmeübertragungsblock (83b) das leitfähige Element ist, und die obere Oberfläche des fünften oberen Wärmeübertragungsblocks (83c) in Kontakt mit der oberen Oberfläche des oberen Elektrodenblocks (16, 26, 36, 46) des vierten (40) Halbleiterlasermoduls steht.

12. Halbleiterlaservorrichtung (100, 200, 300, 400) nach Anspruch 11, wobei der zusätzliche Wärmeableitungsblock (80) eine Einströmungsöffnung und eine Ausströmungsöffnung für ein Kühlmittel umfasst, die an einer Seite bereitgestellt sind, die in der Draufsicht einer Einströmungsöffnung und einer Ausströmungsöffnung für ein Kühlmittel entgegengesetzt ist, die in dem Wärmeableitungsblock (60, 70) bereitgestellt sind.

13. Halbleiterlaservorrichtung (100, 200, 300, 400) nach einem der Ansprüche 8 bis 12, wobei

der obere Elektrodenblock (16, 26, 36, 46) von jedem von dem ersten (10) bis vierten (40) Halbleiterlasermodul (10, 20, 30, 40) in der Draufsicht in seiner äußeren Form identisch ist, und der untere Elektrodenblock (11, 21, 31, 41) von jedem von dem ersten (10) bis vierten (40) Halbleiterlasermodul (10, 20, 30, 40) in der Draufsicht in seiner äußeren Form identisch ist.

14. Halbleiterlaservorrichtung (100, 200, 300, 400) nach Anspruch 13, wobei der obere Elektrodenblock (16, 26, 36, 46) von jedem von dem ersten (10) bis vierten (40) Halbleiterlasermodul (10, 20, 30, 40) und der untere Elektrodenblock (11, 21, 31, 41) von jedem von dem ersten (10) bis vierten (40) Halbleiterlasermodul (10, 20, 30, 40) in der Draufsicht in ihrer äußeren Form identisch sind.

15. Halbleiterlaservorrichtung (100, 200, 300, 400) nach einem der Ansprüche 8 bis 14, wobei

der untere Elektrodenblock (11, 21, 31, 41) von jedem von dem ersten (10) und dritten (30) Halbleiterlasermodul (10, 20, 30, 40) mit einem vertieften Abschnitt (11b, 26c, 31b, 46c) zum Aufnehmen des Submounts (13, 23, 33, 43) und des Halbleiterlaserelements (14, 24, 34, 44) gebildet ist, und der obere Elektrodenblock (16, 26, 36, 46) von jedem von dem zweiten (20) und vierten (40) Halbleiterlasermodul (10, 20, 30, 40) mit einem vertieften Abschnitt (11b, 26c, 31b, 46c) zum Aufnehmen des Submounts (13, 23, 33, 43) und des Halbleiterlaserelements (14, 24, 34, 44) gebildet ist.

**Revendications**

1. Dispositif laser à semi-conducteur (100 200 300 400) comprenant au moins :

un bloc de dissipation thermique (60 70) dont l'intérieur est pourvu d'un chemin d'écoulement (66 76) à travers lequel circule un fluide de refroidissement ; et un premier (10) module laser à semi-conducteur et un deuxième (20) module laser à semi-conducteur disposés sur le bloc de dissipation thermique (60 70), le bloc de dissipation thermique (60 70) comportant :

un bloc de dissipation thermique inférieur (61 71) formé avec une rainure (65) constituant le chemin d'écoulement (66 76) ;

un produit d'étanchéité isolant (62 72) disposé en contact avec une surface supérieure du bloc de dissipation thermique inférieur (61 71) ayant une ouverture au-dessus de la rainure (65) ; et

un bloc de dissipation thermique supérieur (63a 63b 73 73a) réalisé en un matériau conducteur d'électricité, disposé en contact avec une surface supérieure du produit d'étanchéité isolant (62 72) recouvrant l'ouverture,

le premier (10) module laser à semi-conducteur étant disposé en contact avec une surface supérieure du bloc de dissipation thermique supérieur (63a 63b 73 73a) ayant un côté électrode positive orienté vers le bas et en contact électrique avec le bloc de dissipation thermique supérieur ;

le deuxième (20) module laser à semi-conducteur étant disposé en contact avec la surface supérieure du bloc de dissipation thermique supérieur (63a 63b 73 73a) ayant un côté électrode négative orienté vers le bas et en contact électrique avec le bloc de dissipation thermique supérieur

2. Dispositif laser à semi-conducteur (100 200 300 400) selon la revendication 1, dans lequel

les premier (10) et deuxième (20) modules laser à semi-conducteur (10 20 30 40) comportent chacun un bloc d'électrode inférieur (11 21 31 41), une embase (13 23 33 43) qui est connectée électriquement au bloc d'électrode inférieur (11 21 31 41), un élément laser à semi-conducteur (14 24 34 44) qui est disposé sur l'embase (13 23 33 43) et qui est connecté électriquement à l'embase (13 23 33 43) et au bloc d'électrode inférieur (11 21 31 41), et un bloc d'électrode supérieur (16 26 36 46) qui est fourni de sorte à maintenir l'embase (13 23 33 43) et l'élément laser à semi-conducteur (14 24 34 44) avec le bloc d'électrode inférieur (11 21 31 41), et qui est connecté électriquement à l'élément laser à semi-conducteur (14 24 34 44) tout en étant isolé électriquement du bloc d'électrode inférieur (11 21 31 41) à l'aide d'une couche isolante (12), et

le bloc d'électrode inférieur (11 21 31 41) de chacun des premier (10) et deuxième (20) modules laser à semi-conducteur (10 20 30 40) est disposé en contact avec la surface supérieure du bloc de dissipation thermique supérieur (63a 63b 73 73a).

3. Dispositif laser à semi-conducteur (100 200 300 400) selon la revendication 2, dans lequel un bloc de dissipation thermique supplémentaire (80) est disposé en contact avec la surface supérieure du bloc d'électrode supérieur (16 26 36 46) de chacun des premier (10) et deuxième (20) modules laser à semi-conducteur (10 20 30 40).

4. Dispositif laser à semi-conducteur (100 200 300 400) selon la revendication 3, dans lequel

le bloc de dissipation thermique supplémentaire (80) comporte un bloc de dissipation thermique inférieur (81) formé avec une rainure (85) constituant un chemin d'écoulement (86) à travers lequel circule un fluide de refroidissement, un produit d'étanchéité isolant (82) disposé en contact avec une surface supérieure du bloc de dissipation thermique inférieur (81) ayant une ouverture au-dessus de la rainure (85), et un bloc de dissipation thermique supérieur (83a 83b 83c) disposé en contact avec une surface supérieure du produit d'étanchéité isolant (82) recouvrant l'ouverture, et

le bloc de dissipation thermique supplémentaire est disposé avec une surface supérieure du bloc de dissipation thermique supérieur (83a 83b 83c) en contact avec la surface supérieure du bloc d'électrode supérieur (16 26 36 46) de chacun des premier (10) et deuxième (20) modules laser à semi-conducteur (10 20 30 40).

5. Dispositif laser à semi-conducteur (100 200 300 400) selon l'une quelconque des revendications 2 à 4, dans lequel

le bloc d'électrode supérieur (16 26 36 46) du premier (10) module laser à semi-conducteur et le bloc d'électrode supérieur (16 26 36 46) du deuxième (20) module laser à semi-conducteur ont la même forme extérieure en vue de dessus, et

le bloc d'électrode supérieur (16 26 36 46) du premier (10) module laser à semi-conducteur et le bloc d'électrode inférieur (11 21 31 41) du deuxième (20) module laser à semi-conducteur ont la même forme extérieure en vue de dessus.

6. Dispositif laser à semi-conducteur (100 200 300 400) selon la revendication 5, dans lequel le bloc d'électrode supérieur (16 26 36 46) et le bloc d'électrode inférieur (11 21 31 41) dans chacun des premier (10) et deuxième (20) modules laser à semi-conducteur (10 20 30 40) ont la même forme extérieure en vue de dessus.

7. Dispositif laser à semi-conducteur (100 200 300 400) selon l'une quelconque des revendications 2 à 6, dans lequel

le bloc d'électrode inférieur (11 21 31 41) du premier (10) module laser à semi-conducteur est formé d'une partie évidée (11b 26c 31b 46c) pour loger l'embase (13 23 33 43) et l'élément laser à semi-conducteur (14 24 34 44), et

le bloc d'électrode supérieur (16 26 36 46) du deuxième (20) module laser à semi-conducteur est formé d'une partie évidée (11b 26c 31b 46c) pour loger l'embase (13 23 33 43) et l'élément laser à semi-conducteur (14 24 34 44).

8. Dispositif laser à semi-conducteur (100 200 300 400) selon la revendication 2, comprenant en outre :

des troisième (30) et quatrième modules laser à semi-conducteur (10 20 30 40) disposés sur le bloc de dissipation thermique (60 70),

dans lequel

le bloc de dissipation thermique (60 70) comporte au moins le bloc de dissipation thermique inférieur (61 71), un produit d'étanchéité isolant (62 72) qui est disposé en contact avec la surface supérieure du bloc de dissipation thermique inférieur (61 71) ayant au moins deux ouvertures formées au-dessus de la rainure (65) à un intervalle, et des premier (63a) et deuxième (63b) blocs de dissipation thermique supérieurs (63a 63b 73 73a) disposés en contact avec une surface supérieure du produit d'étanchéité isolant (62 72) à un intervalle, recouvrant les deux ouvertures correspondantes,

les premier (63a) et deuxième (63b) blocs de dissipation thermique supérieurs (63a 63b 73 73a) sont chacun réalisés en un matériau conducteur d'électricité,

le premier (10) module laser à semi-conducteur est disposé en contact avec une surface supérieure du premier bloc de dissipation thermique supérieur (63a) ayant un côté électrode positive orienté vers le bas et en contact électrique avec le premier bloc de dissipation thermique supérieur,

et le deuxième (20) module laser à semi-conducteur est disposé en contact avec la surface supérieure du premier bloc de dissipation thermique supérieur (63a) ayant un côté électrode négative orienté vers le bas et en contact électrique avec le premier bloc de dissipation thermique supérieur ;

le troisième (30) module laser à semi-conducteur est disposé en contact avec une surface supérieure du deuxième bloc de dissipation thermique supérieur (63b) ayant un côté électrode positive orienté vers le bas et en contact électrique avec le deuxième bloc de dissipation thermique supérieur,

et le quatrième (40) module laser à semi-conducteur est disposé en contact avec la surface supérieure du deuxième bloc de dissipation thermique supérieur (63b) ayant un côté électrode négative orienté vers le bas et en contact électrique avec le deuxième bloc de dissipation thermique supérieur , et

le côté électrode positive du deuxième (20) module laser à semi-conducteur et le côté électrode négative du troisième (30) module laser à semi-conducteur sont connectés électriquement à l'aide d'un organe conducteur.

9. Dispositif laser à semi-conducteur (100 200 300 400) selon la revendication 8, dans lequel

les troisième (30) et quatrième (40) modules laser à semi-conducteur (10 20 30 40) comportent chacun un bloc d'électrode inférieur (11 21 31 41), une embase (13 23 33 43) qui est connectée électriquement au bloc d'électrode inférieur (11 21 31 41), un élément laser à semi-conducteur (14 24 34 44) qui est disposé sur l'embase (13 23 33 43) et qui est connecté électriquement à l'embase (13 23 33 43) et au bloc d'électrode inférieur (11 21 31 41), et un bloc d'électrode supérieur (16 26 36 46) qui est fourni de sorte à maintenir l'embase (13 23 33 43) et l'élément laser à semi-conducteur (14 24 34 44) avec le bloc d'électrode inférieur (11 21 31 41), et qui est connecté électriquement à l'élément laser à semi-conducteur (14 24 34 44) tout en étant isolé électriquement du bloc d'électrode inférieur (11 21 31 41) à l'aide d'une couche isolante (12),

le bloc d'électrode inférieur (11 21 31 41) de chacun des premier (10) et deuxième (20) modules laser à semi-conducteur (10 20 30 40) est disposé en contact avec la surface supérieure du premier bloc de dissipation thermique supérieur (63a), et

le bloc d'électrode inférieur (11 21 31 41) de chacun des troisième (30) et quatrième (40) modules laser à semi-conducteur (10 20 30 40) est disposé en contact avec la surface supérieure du deuxième bloc de dissipation thermique supérieur (63b).

10. Dispositif laser à semi-conducteur (100 200 300 400) selon la revendication 9, comprenant en outre un bloc de dissipation thermique supplémentaire (80) qui est disposé en contact avec une surface supérieure du bloc d'électrode supérieur (16 26 36 46) de chacun des premier (10) à quatrième (40) modules laser à semi-conducteur (10 20 30 40).

11. Dispositif laser à semi-conducteur (100 200 300 400) selon la revendication 10, dans lequel

le bloc de dissipation thermique supplémentaire (80) comporte un bloc de dissipation thermique inférieur (81) formé avec une rainure (85) constituant un chemin d'écoulement (86) à travers lequel circule un fluide de refroidissement, un produit d'étanchéité isolant (82) qui est disposé en contact avec une surface supérieure du bloc de dissipation thermique inférieur (81) et qui a au moins trois ouvertures formées au-dessus de la rainure (85) par intervalles, et des troisième à cinquième blocs de dissipation thermique supérieurs conducteurs d'électricité (83a 83b 83c) qui sont disposés en contact avec une surface supérieure du produit d'étanchéité isolant (82) par intervalles recouvrant les trois ouvertures correspondantes,

le bloc de dissipation thermique supplémentaire (80) est disposé sur la surface supérieure du bloc d'électrode supérieur (16 26 36 46) de chacun des premier (10) à quatrième (40) modules laser à semi-conducteur (10 20 30 40), une surface supérieure de chacun des troisième à cinquième blocs de dissipation thermique supérieurs (83a 83b 83c) étant orientée vers le bas,

la surface supérieure du troisième bloc de dissipation thermique supérieur (83a) est en contact avec la surface supérieure du bloc d'électrode supérieur (16 26 36 46) du premier (10) module laser à semi-conducteur,

la surface supérieure du quatrième bloc de dissipation thermique supérieur (83b) est en contact avec la surface supérieure du bloc d'électrode supérieur (16 26 36 46) de chacun des deuxième (20) et troisième (30) modules laser à semi-conducteur (10 20 30 40),

dans lequel le quatrième bloc de dissipation thermique supérieur (83b) est ledit organe conducteur, et

la surface supérieure du cinquième bloc de dissipation thermique supérieur (83c) est en contact avec la surface supérieure du bloc d'électrode supérieur (16 26 36 46) du quatrième (40) module laser à semi-conducteur.

12. Dispositif laser à semi-conducteur (100 200 300 400) selon la revendication 11, dans lequel le bloc de dissipation thermique supplémentaire (80) comporte un orifice d'écoulement à l'entrée et un orifice de décharge de fluide de refroidissement qui sont prévus sur un côté opposé à un orifice d'écoulement à l'entrée et un orifice de décharge de fluide de refroidissement prévu dans le bloc de dissipation thermique (60 70) en vue de dessus.

13. Dispositif laser à semi-conducteur (100 200 300 400) selon l'une quelconque des revendications 8 à 12, dans lequel

les bloc d'électrode supérieurs (16 26 36 46) des premier (10) à quatrième (40) modules laser à semi-conducteur (10 20 30 40) ont la même forme extérieure en vue de dessus, et

les blocs d'électrode inférieurs (11 21 31 41) des premier (10) à quatrième (40) modules laser à semi-conducteur (10 20 30 40) ont la même forme extérieure en vue de dessus.

14. Dispositif laser à semi-conducteur (100 200 300 400) selon la revendication 13, dans lequel le bloc d'électrode supérieur (16 26 36 46) de chacun des premier (10) à quatrième (40) modules laser à semi-conducteur (10 20 30 40) et le bloc d'électrode inférieur (11 21 31 41) de chacun des premier (10) à quatrième (40) modules laser à semi-conducteur (10 20 30 40) ont la même forme extérieure en vue de dessus.

15. Dispositif laser à semi-conducteur (100 200 300 400) selon l'une quelconque des revendications 8 à 14, dans lequel

le bloc d'électrode inférieur (11 21 31 41) de chacun des premier (10) et troisième (30) modules laser à semi-conducteur (10 20 30 40) est formé avec une partie évidée (11b 26c 31b 46c) pour loger l'embase (13 23 33 43) et l'élément laser à semi-conducteur (14 24 34 44), et

le bloc d'électrode supérieur (16 26 36 46) de chacun des deuxième (20) et quatrième (40) modules laser à semi-conducteur (10 20 30 40) est formé avec une partie évidée (11b 26c 31b 46c) pour loger l'embase (13 23 33 43) et l'élément laser à semi-conducteur (14 24 34 44).

# FIG. 1

EP 3 799 229 B1

# FIG. 2

EP 3 799 229 B1

# FIG. 3

# FIG. 4A

# FIG. 4B

# FIG. 5A

FIG. 5B

EP 3 799 229 B1

# FIG. 6A

# FIG. 6B

# FIG. 7

# FIG. 8

EP 3 799 229 B1

# FIG. 9

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2016103536 A
- JP 2008172141 A
- JP 3951919 B
- EP 2485346 A2